# EUROPEAN PATENT SPECIFICATION

(11) **EP 2 026 379 B1**
(45) Date of publication and mention of the grant of the patent: **15.08.2012**
(21) Application number: 07743957.8
(22) Date of filing: 23.05.2007
(51) Int. Cl.: H01L 23/15, H01L 23/13, H01L 21/48

(54) **MULTILAYER CERAMIC ELECTRONIC COMPONENT AND METHOD FOR MANUFACTURING SAME**
MEHRSCHICHTIGE KERAMISCHE ELEKTRONISCHE KOMPONENTE UND HERSTELLUNGSVERFAHREN DAFÜR
COMPOSANT ELECTRONIQUE DE CERAMIQUE MULTICOUCHE ET SON PROCEDE DE FABRICATION

(30) Priority: 02.06.2006 JP 2006155401
(43) Date of publication of application: 18.02.2009
(73) Proprietor: MURATA MANUFACTURING CO., LTD., Nagaokakyo-shi, Kyoto 6178-8555 (JP)
(72) Inventor: NOMIYA, Masato c/o Murata Manufacturing Co., Ltd, Nagaokakyo-shi, Kyoto-fu 617-8555 (JP); SAKAI, Norio c/o Murata Manufacturing Co., Ltd, Nagaokakyo-shi, Kyoto-fu 617-8555 (JP); NISHIDE, Mitsuyoshi c/o Murata Manufacturing Co., Ltd, Nagaokakyo-shi, Kyoto-fu 617-8555 (JP)
(74) Representative: Zinkler, Franz
(86) International application number: PCT/JP2007/060523
(87) International publication number: WO 2007/142033

(56) References cited:
- JP-A- 2004 055 728
- JP-A- 2005 039 239
- JP-A- 2005 050 881
- US-A1- 2003 211 302
- US-A1- 2005 023 032
- US-A1- 2005 023 033

## Description

### Technical Field

The present invention relates to an electronic device and a method for manufacturing the same. In particular, the present invention relates to a multilayer ceramic electronic device in which a surface mount electronic device is mounted on a multilayer ceramic element assembly and a method for manufacturing the same.

### Background Art

In recent years, performance of electronic devices in electronics field has improved significantly and contributed to increases in information processing speed, miniaturization of apparatuses, and expansion in functionality of information processing apparatuses, e.g., large-scale computers, mobile communication terminals, and personal computers.

A multi-chip module (MCM) in which a plurality of semiconductor devices, e.g., VLSIs and ULSIs, are mounted on a ceramic substrate is mentioned as one of such electronic devices. In such a module, a ceramic multilayer substrate, in which wiring conductors are three-dimensionally disposed, is used widely in order to increase the packaging density of LSIs and electrically connect between LSIs reliably.

This ceramic multilayer substrate is formed by laminating a plurality of ceramic layers and is provided with wiring conductors for constituting circuits on the surface or in the inside thereof. Regarding mobile communication terminals typified by cellular phones, automobile radio communication apparatuses, and the like, demands for high-performance, high-density mounting have been strengthened and further miniaturization has been required. Furthermore, demands for the impact resistance of products including ceramic multilayer substrates have been intensified more and more from the viewpoint of uses and the like thereof.

By the way, as for a method for mounting a semiconductor device and the like on a substrate, a mounting method has been proposed, in which solder balls (bumps) 54 provided on a semiconductor element 53 are fusion-bonded to an electrically conductive pattern 52 formed on a substrate 51 by using via electrodes, printed electrodes, and the like, and, in addition, a thermosetting resin 55 serving as an impact relaxation layer is filled between the substrate 51 and the semiconductor element 53, as shown in Fig. 18, for the purpose of improving the impact resistance (Patent Document 1).

These mounting method and mounting structure are effective at improving the impact resistance and can contribute to an improvement of the impact resistance of products including ceramic multilayer substrates. However, in the case where adaptation of such a mounting structure is intended, further reduction in area of an electrically conductive pattern, that is, a surface electrode, is necessary in order to miniaturize a product.

However, if the area of the surface electrode for ensuring the electrical conductivity is reduced, the diameter of the solder ball needs to decrease, the distance between the substrate 51 and the semiconductor element 53 decreases, the thickness of the thermosetting resin (impact relaxation layer) 55 filled therein decreases, and a situation in which the impact resistance becomes insufficient with respect to even a ceramic multilayer substrate provided with the mounting structure disclosed in Patent Document 1 occurs.

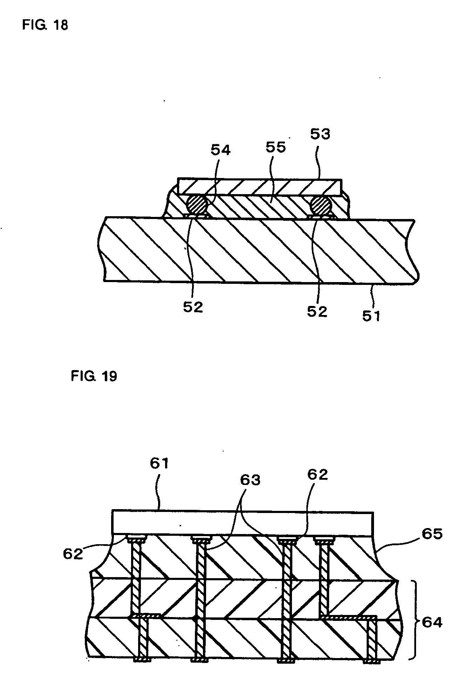

Furthermore, as for a mounting structure of a semiconductor element in related art, a mounting structure (semiconductor apparatus) has been proposed, in which, for example, as shown in Fig. 19, electrodes 62 formed on a back surface of a semiconductor element 61 are mounted on a multilayer circuit board 64 having a plurality of protruded electrodes 63 with top portions formed from an electrically conductive adhesive and adjusted to become flush with each other, the electrodes 62 of the semiconductor element 61 and the top portions of the protruded electrodes 63 are electrically connected, and a shrinkable insulating resin layer 65 is filled in a gap between the semiconductor element 61 and the multilayer circuit board 64 (Patent Document 2).

Moreover, it is believed that in the case of the mounting structure disclosed in Patent Document 2, regarding a semiconductor apparatus including the semiconductor element 61 mounted on the multilayer circuit board 64, the semiconductor element 61 can be mounted with high reliability without requiring the multilayer circuit board 64 to have severe flatness.

However, as for the above-described mounting structure in related art, there are limits of diameter reduction of the protruded electrode (columnar electrode) 63, an improvement in aspect ratio, i.e. a ratio of the height to the diameter (height/diameter) of the protruded electrode (columnar electrode) 63, and reduction in distance between adjacent protruded electrodes (columnar electrodes) 63. Therefore, the fact is that it is difficult to meet the demand for protruded electrodes (columnar electrodes) 63 having smaller diameters and high aspect ratios satisfactorily.

Furthermore, as for the mounting structure disclosed in Patent Document 2, it is necessary to dispose the resin between the semiconductor element 61 and the multilayer circuit board 64 by injection after the semiconductor element 61 is mounted. However, the resin leaks from a lower region of the semiconductor element 61 to the surrounding region because of the fluidity of the resin and the state of leakage fluctuates. Therefore, in the mounting of surface mount electronic devices other than the semiconductor element 61 on regions surrounding the semiconductor element 61, regions close to the region on which the semiconductor element 61 has been mounted cannot be used as mounting spaces effectively. Consequently, there is a problem in that high-density mounting of surface mount electronic devices is prevented. Patent document 3 discloses a semiconductor element with a substrate and an intermediate substrate where a resin is injected between the semiconductor element and the substrate and between the substrate and the intermediate substrate.
Patent Document 1: Japanese Unexamined Utility Model Registration Application Publication No. 4-99834
Patent Document 2: Japanese Unexamined Patent Application Publication No. 11-26631 Patient document 3: United States Patent Application Publication US2005/0023033

### Disclosure of Invention

### Problems to be Solved by the Invention

The present invention is to solve the above-described problems. It is an object of the present invention to provide a method for manufacturing a multilayer ceramic electronic device, wherein leakage of an underfill resin for fixing a surface mount electronic device does not occur and high-density, high-accuracy mounting of a device can be conducted, and a highly reliable multilayer ceramic electronic device which is produced by the above-described manufacturing method and which has excellent impact resistance and excellent compatibility with miniaturization.

### Means for Solving the Problems

In order to solve the above-described problems, a method for manufacturing a multilayer ceramic electronic device according to Claim 1 of the present invention is a method for manufacturing a multilayer ceramic electronic device in which a surface mount electronic device is mounted on a first principal surface of a multilayer ceramic element assembly, the method characterized by including the steps of
(a) preparing an unfired seat-portion-equipped multilayer ceramic element assembly provided with
   an unfired multilayer ceramic element assembly in which unsintered ceramic base material layers are laminated and a predetermined first conductor pattern is disposed and
   a seat portion for mounting the above-described surface mount electronic device, the seat portion being disposed in at least a partial region of the above-described first principal surface of the above-described multilayer ceramic element assembly, containing a nonmetallic inorganic powder as a primary component, having a second conductor pattern connected to the above-described surface mount electronic device, and having a resin introduction portion located outside a vertically projected region of the above-described surface mount electronic device,
(b) firing the above-described unfired seat-portion-equipped multilayer ceramic element assembly,
(c) mounting the above-described surface mount electronic device on the above-described seat portion of the fired seat-portion-equipped multilayer ceramic element assembly with the above-described second conductor pattern therebetween, and
(d) filling a resin from the above-described resin introduction portion into the above-described seat portion containing the above-described nonmetallic inorganic powder as the primary component and between the above-described seat portion and the above-described surface mount electronic device and conducting curing.

A method for manufacturing a multilayer ceramic electronic device according to Claim 2 is characterized in that in the configuration of the invention according to Claim 1, the above-described seat portion containing the above-described nonmetallic inorganic powder as the primary component is formed from a porous ceramic compact.

A method for manufacturing a multilayer ceramic electronic device according to Claim 3 is characterized in that in the configuration of the invention according to Claim 1 or Claim 2, the above-described unsintered ceramic base material layers and shrinkage restriction layers for restricting shrinkage of the above-described unsintered ceramic base material layers in a plane direction are laminated so as to form the above-described unfired multilayer ceramic element assembly.

A method for manufacturing a multilayer ceramic electronic device according to Claim 4 is characterized in that in the configuration of the invention according to any one of Claims 1 to 3, the above-described seat portion is provided with via hole conductors as the above-described second conductor pattern while one end surface of each via hole conductor is exposed at the surface of the above-described seat portion, and the above-described surface mount electronic device is mounted on the one end surface of each via hole conductor exposed at the above-described surface with an electrically conductive jointing member therebetween.

A method for manufacturing a multilayer ceramic electronic device according to Claim 5 is characterized in that in the configuration of the invention according to any one of Claims 1 to 4, the above-described second conductor pattern of the above-described seat portion connects the above-described surface mount electronic device mounted on the above-described seat portion and the above-described first conductor pattern of the above-described multilayer ceramic element assembly.

A method for manufacturing a multilayer ceramic electronic device according to Claim 6 is characterized in that in the configuration of the invention according to any one of Claims 1 to 5, the above-described surface mount electronic device is a semiconductor element.

A method for manufacturing a multilayer ceramic electronic device according to Claim 7 is characterized in that in the configuration of the invention according to any one of Claims 1 to 6, in the case where a plurality of surface mount electronic devices are mounted on the above-described seat portion, a resin introduction portion common to the individual surface mount electronic devices is disposed on the above-described seat portion, the resin is filled from the above-described common resin introduction portion so as to fill the resin into the above-described seat portion and between the above-described seat portion and the plurality of surface mount electronic devices.

A method for manufacturing a multilayer ceramic electronic device according to Claim 8 is characterized in that in the configuration of the invention according to any one of Claims 1 to 7, surface mount electronic devices other than the above-described surface mount electronic device mounted on the above-described seat portion are mounted on regions, in which the above-described seat portion is not disposed, of the above-described first principal surface of the above-described multilayer ceramic element assembly.

A method for manufacturing a multilayer ceramic electronic device according to Claim 9 is characterized in that in the configuration of the invention according to any one of Claims 4 to 8, an unfired multilayer ceramic element assembly having a structure in which the above-described shrinkage restriction layer is disposed on the above-described first principal surface side is formed as the above-described unfired multilayer ceramic element assembly.

A method for manufacturing a multilayer ceramic electronic device according to Claim 10 is characterized in that in the configuration of the invention according to any one of Claims 1 to 9, a region other than the above-described resin introduction portion in the above-described seat portion is located inside the vertically projected region of the above-described surface mount electronic device mounted on the above-described seat portion.

A method for manufacturing a multilayer ceramic electronic device according to Claim 11 is characterized in that in the configuration of the invention according to any one of Claims 1 to 10, the thickness of the above-described seat portion is 15 to 150 µm.

A method for manufacturing a multilayer ceramic electronic device according to Claim 12 is characterized in that in the configuration of the invention according to any one of Claims 4 to 11, the above-described unsintered ceramic base material layer is an unsintered ceramic base material layer containing low-temperature-sinterable ceramic as a primary component and the above-described shrinkage restriction layer is a shrinkage restriction layer containing hard-to-sinter ceramic, which is substantially not sintered at a sintering temperature of the above-described low-temperature-sinterable ceramic, as a primary component.

A method for manufacturing a multilayer ceramic electronic device according to Claim 13 characterized in that in the configuration of the invention according to any one of Claims 1 to 12, the above-described nonmetallic inorganic powder constituting the above-described seat portion is a ceramic powder which is substantially not sintered at a sintering temperature of the ceramic constituting the above-described unsintered ceramic base material layer.

A multilayer ceramic electronic device according to Claim 14 is a multilayer ceramic electronic device in which a surface mount electronic device is mounted on a first principal surface of a multilayer ceramic element assembly, the multilayer ceramic electronic device being characterized by including
a multilayer ceramic element assembly in which ceramic base material layers are laminated and a predetermined first conductor pattern is disposed,
a seat portion cofired with said multilayer ceramic element assembly for mounting the above-described surface mount electronic device, the seat portion being disposed in at least a partial region of the above-described first principal surface of the above-described multilayer ceramic element assembly, containing a nonmetallic inorganic powder as a primary component, having a second conductor pattern connected to the above-described surface mount electronic device, and having a resin introduction portion located outside a vertically projected region of the above-described surface mount electronic device, and
the surface mount electronic device mounted on the above-described seat portion with the above-described second conductor pattern therebetween,
wherein a resin is filled in at least the above-described seat portion containing the above-described nonmetallic inorganic powder as the primary component.

A multilayer ceramic electronic device according to Claim 15 is characterized in that in the configuration of the invention according to Claim 14, resins having the same composition are filled in the above-described seat portion containing the above-described nonmetallic inorganic powder as a primary component and between the above-described seat portion and the above-described surface mount electronic device, the resins being filled through the above-described resin introduction portion.

A multilayer ceramic electronic device according to Claim 16 is characterized in that in the configuration of the invention according to Claim 14 or 15, the above-described surface mount electronic device is electrically connected to the above-described first conductor pattern of the above-described multilayer ceramic element assembly with the above-described second conductor pattern of the above-described seat portion therebetween.

### Advantages

In the method for manufacturing a multilayer ceramic electronic device according to Claim 1 of the present invention, the unfired seat-portion-equipped multilayer ceramic element assembly provided with the unfired multilayer ceramic element assembly, in which the unsintered ceramic base material layers are laminated and the predetermined first conductor pattern is disposed, and the seat portion, which is disposed in at least a partial region of the above-described first principal surface of the above-described multilayer ceramic element assembly, which contains the nonmetallic inorganic powder as the primary component, which has the second conductor pattern connected to the surface mount electronic device, and which has the resin introduction portion located outside the vertically projected region of the surface mount electronic device, is formed. After this is fired, the surface mount electronic device is mounted on the seat portion, and the resin is filled from the resin introduction portion into the seat portion and between the seat portion and the surface mount electronic device. Consequently, the seat portion is allowed to have a structure in which an aggregate of the nonmetallic inorganic powder is impregnated with the resin. Therefore, the seat portion can be adhered reliably to the first principal surface of the multilayer ceramic element assembly, so that it becomes possible to obtain the multilayer ceramic electronic device provided with the seat portion having high mechanical strength and exhibiting excellent bonding strength with respect to the multilayer ceramic element assembly.

In the present invention, since the seat portion has the resin introduction portion located outside the vertically projected region of the surface mount electronic device, the resin can be easily reliably filled in the seat portion, to be more precise, gaps in the nonmetallic inorganic powder constituting the seat portion, and gaps between the seat portion and the surface mount electronic device through capillarity merely by, for example, supplying the resin to the resin introduction portion of the seat portion from above.

Furthermore, the seat portion is the aggregate of the nonmetallic inorganic powder, and the resin filled through the resin introduction portion is held reliably in the seat portion and the gaps between the seat portion and the surface mount electronic device. Therefore, the resin does not leak from the seat portion to the surroundings, so that an adverse effect due to leakage of the resin can be suppressed from being exerted on the surrounding regions.

As the result of suppression and prevention of leakage of the resin from the region in which the seat portion is disposed to the surrounding regions or to the regions adjacent to the region occupied by the surface mount electronic device mounted on the seat portion, distances between the seat portion and the other surface mount electronic devices disposed in the regions surrounding the seat portion can be designed to become narrow (designed to become narrow gaps), and other surface mount electronic devices can be mounted densely in the surroundings of the surface mount electronic device mounted on the seat portion, so that high-density, high-accuracy mounting form can be realized.

Moreover, the resin filled between the surface mount electronic device and the seat portion functions as a bonding layer to bond the surface mount electronic device and the seat portion and, in addition, serves as an impact absorption layer. Therefore, the impact resistance can be improved while the surface mount electronic device is fixed to the seat portion reliably.

Therefore, according to the invention related to Claim 1, a highly reliable multilayer ceramic electronic device can be produced effectively, wherein leakage of an underfill resin for fixing a surface mount electronic device does not occur and high-density, high-accuracy mounting of a surface mount electronic device is conducted.

Incidentally, in the present invention, for example, transistor, ICs, and LSIs are mentioned as examples of the surface mount electronic device mounted on the seat portion. However, the structure of the multilayer ceramic electronic device according to the present invention is suitable for a mounting structure of a surface mount electronic device including a plurality of narrow-gap I/O terminals at a high density in substantially the same plane and, therefore, is particularly useful in the case where BGA (Ball Grid Array) connection type large-scale semiconductor elements, e.g., ICs and LSIs, are mounted in the state of bare chips.

Even in the case where a configuration does not include the resin introduction portion which is provided on the seat portion in the present invention, by devising the form of resin supply, the resin can be filled into the seat portion while leakage of the resin to the surroundings of the seat portion is suppressed and prevented. However, according to the present invention, as described above, the resin can be filled in the seat portion and between the seat portion and the surface mount electronic device while leakage of the resin to the surroundings of the seat portion is suppressed and prevented merely by supplying the resin to the resin introduction portion located outside the vertically projected region of the surface mount electronic device. Therefore, it is clear that the present invention is useful from the viewpoint of simplification of production facilities, simplification of production steps, ease of mounting of surface mount electronic devices, compatibility with high-density mounting, and the like.

As in the method for manufacturing a multilayer ceramic electronic device according to Claim 2, in the case where the seat portion containing the nonmetallic powder as the primary component is formed from the porous ceramic compact in the configuration of the invention according to Claim 1, the resin penetrates and infiltrates selectively into the porous seat portion 11 and between the semiconductor element 13 and the seat portion 11 through capillarity and, therefore, leakage of the resin filled from the resin introduction portion to the outside of the seat portion can be suppressed effectively.

As in the method for manufacturing a multilayer ceramic electronic device according to Claim 3, in the case where the unfired multilayer ceramic element assembly is formed to have the structure in which the unsintered ceramic base material layers and the shrinkage restriction layers are laminated in the configuration of the invention according to Claim 1 or Claim 2, shrinkage in a direction orthogonal to a lamination direction (plane direction of the unsintered ceramic base material layer) in a firing step is suppressed and prevented, so that a multilayer ceramic electronic device having good dimensional accuracy and high reliability can be obtained.

As in the method for manufacturing a multilayer ceramic electronic device according to Claim 4, in the configuration of the invention according to any one of Claims 1 to 3, the second conductor pattern of the seat portion is made to be via hole conductors while one end surface of each via hole conductor is exposed at the surface of the seat portion, and the surface mount electronic device is mounted on the one end surface of each via hole conductor exposed at the surface with an electrically conductive jointing member therebetween, so that the reliability in connection and fixing of the surface mount electronic device to the seat portion can be improved.

That is, in the multilayer ceramic electronic device produced by the method for manufacturing a multilayer ceramic electronic device according to Claim 4, the surface mount electronic device is bonded to the above-described one end surface of the via hole conductor (columnar electrode) disposed in such a way that the one end surface is exposed at the surface of the seat portion with an electrically conductive jointing member, e.g., solder, therebetween. Therefore, the surface mount electronic device can be bonded to the multilayer ceramic element assembly reliably with the seat portion therebetween, so that excellent impact resistance can also be realized as compared with the case where a surface mount electronic device and a thin-film shaped electrode of a substrate form electrical bonding directly in related art. Consequently, even if an impact is applied to the multilayer ceramic element assembly, the seat portion suppress transfer of the impact to the bonding portion of the surface mount electronic device and the electrically conductive jointing member, so that a connection structure of the surface mount electronic device can be obtained, wherein the reliability in connection is not impaired by a stronger impact.

As in the method for manufacturing a multilayer ceramic electronic device according to Claim 5, in the case where the second conductor pattern of the seat portion connects the surface mount electronic device and the first conductor pattern of the multilayer ceramic element assembly in the configuration of the invention according to any one of Claims 1 to 4, mechanical connection and electrical connection of the surface mount electronic device can be conducted at the same time, so that miniaturization of a product and simplification of a configuration can be realized.

As in the method for manufacturing a multilayer ceramic electronic device according to Claim 6, in the case where the semiconductor element is mounted on the seat portion in the configuration of the invention according to any one of Claims 1 to 5, the present invention is allowed to become more effective. That is, as described above, the multilayer ceramic electronic device according to the present invention is suitable for bare chip mounting of a BGA connection type semiconductor element including a plurality of narrow-gap I/O terminals at a high density in substantially the same plane. Therefore, as in the method for manufacturing a multilayer ceramic electronic device according to Claim 6, in the case where BGA connection type large-scale semiconductor elements, e.g., ICs and LSIs, are mounted in the state of bare chips, high-density, high-accuracy mounting can be conducted so that usefulness is exerted particularly.

As in the method for manufacturing a multilayer ceramic electronic device according to Claim 7, in the case where the plurality of surface mount electronic devices are mounted on the seat portion, the plurality of surface mount electronic devices can be mounted and fixed to the seat portion efficiently by disposing the resin introduction portion common to the individual surface mount electronic devices on the seat portion and filling the resin from the common resin introduction portion. Therefore, the present invention is allowed to become further effective.

As in the method for manufacturing a multilayer ceramic electronic device according to Claim 8, in the case where other surface mount electronic devices are mounted on regions, in which the seat portion is not disposed, of the first principal surface of the multilayer ceramic element assembly in the configuration of the invention according to any one of Claims 1 to 7, a small, high-performance multilayer ceramic electronic device in which the mounting density of devices is higher can be produced efficiently.

The types of the surface mount electronic device mounted on the regions, in which the seat portion is not disposed, are not specifically limited. Examples thereof include passive elements, e.g., a chip capacity, a chip resistance, a chip thermistor, and a chip inductor, having the number of I/O terminals smaller than that of the surface mount electronic device disposed on the seat portion.

As in the method for manufacturing a multilayer ceramic electronic device according to Claim 9, an unfired multilayer ceramic element assembly having the structure in which the above-described shrinkage restriction layer is disposed on the first principal surface side is formed as the unfired multilayer ceramic element assembly in the configuration of the invention according to any one of Claims 4 to 8, it becomes possible to suppress and prevent shrinkage of the multilayer ceramic element assembly in a plane direction in the firing step further reliably and obtain a multilayer ceramic element assembly having relatively large mechanical strength. Consequently, a multilayer ceramic electronic device having good dimensional accuracy and high reliability can be produced efficiently.

That is, in the case where the shrinkage restriction layer is also disposed on the first principal surface which is the surface of the multilayer ceramic element assembly, a compressive stress due to the ceramic layer occurs with respect to the shrinkage restriction layer. Contrarily, a tensile stress for the purpose of shrinkage compensation due to the shrinkage restriction layer occurs with respect to the ceramic layer. In general, the strength of the ceramic substrate in the state in which a compressive stress is applied to the surface becomes larger. Therefore, it is preferable that the shrinkage restriction layer is also located on the side of the first principal surface which is the surface of the multilayer ceramic element assembly from the viewpoint of an improvement of the strength of the multilayer ceramic element assembly.

As in the method for manufacturing a multilayer ceramic electronic device according to Claim 10, a region other than the resin introduction portion in the seat portion is located inside the vertically projected region of the surface mount electronic device mounted on the seat portion in the configuration of the invention according to any one of Claims 1 to 9, the region, in which the seat portion is not disposed, on the surface of the multilayer ceramic element assembly, that is, a region on which other surface mount electronic devices can be mounted, can be enlarged. Consequently, a small, high-density, high-reliability multilayer ceramic electronic device can be obtained, in which still more surface mount electronic devices are mounted.

As in the method for manufacturing a multilayer ceramic electronic device according to Claim 11, the thickness of the seat portion is specified to be within the range of 15 to 150 µm in the configuration of the invention according to any one of Claims 1 to 10 and, thereby, a highly reliable multilayer ceramic electronic device having excellent impact resistance, excellent compatibility with miniaturization, and good dimensional accuracy can be obtained while an increase in height of the product is suppressed.

If the thickness of the seat portion becomes less than 15 µm, an impact in drop or the like tends to concentrate on the bonding portion between the seat portion and the ceramic element assembly, an effect of suppressing breakage due to an impact is reduced, and the impact resistance becomes insufficient. If the thickness of the seat portion exceeds 150 µm, unfavorably, it becomes difficult to fill the resin into the seat portion sufficiently. Therefore, it is preferable that the thickness of the seat portion is specified to be within the range of 15 to 150 µm.

As in the method for manufacturing a multilayer ceramic electronic device according to Claim 12, the unsintered ceramic base material layer is specified to be an unsintered ceramic base material layer containing low-temperature-sinterable ceramic as a primary component and the shrinkage restriction layer is specified to be a shrinkage restriction layer containing hard-to-sinter ceramic, which is substantially not sintered at a sintering temperature of the low-temperature-sinterable ceramic, as a primary component in the configuration of the invention according to any one of Claims 4 to 11, firing can be conducted reliably at a relatively low temperature without causing shrinkage in a plane direction. Therefore, a highly reliable multilayer ceramic electronic device having good dimensional accuracy in the plane direction and desired characteristics reliably can be obtained while the production cost is reduced.

As in the method for manufacturing a multilayer ceramic electronic device according to Claim 13, the seat portion and the multilayer ceramic element assembly can be fired at the same time by using a ceramic powder which is substantially not sintered at a sintering temperature of the ceramic constituting the ceramic base material layer as the nonmetallic inorganic powder constituting the seat portion in the configuration of the invention according to any one of Claims 1 to 12. Therefore, distortion and deviation in location of the mounting region due to difference in firing shrinkage behavior can be suppressed. Furthermore, gaps are present in the aggregate of the ceramic powder substantially not fired in the firing step to the extent that the aggregate (structure serving as a skeleton of the seat portion) does not collapse. Therefore, the resin can easily penetrate therein, so that the present invention is allowed to become further effective.

A multilayer ceramic electronic device according to Claim 14 has a structure in which a multilayer ceramic element assembly having a predetermined first conductor pattern, a seat portion cofired with said multilayer ceramic element assembly for mounting the surface mount electronic device, the seat portion being disposed in at least a partial region of the first principal surface of the multilayer ceramic element assembly, having a second conductor pattern, including the resin introduction portion located outside the vertically projected region of the surface mount electronic device, and containing a nonmetallic inorganic powder as a primary component, and the surface mount electronic device mounted on the seat portion with the above-described second conductor pattern therebetween, wherein the resin is filled in at least the seat portion. Therefore, the seat portion on which the surface mount electronic device is mounted is fixed to the multilayer ceramic element assembly with the resin firmly.

Since the resin introduction portion located outside the vertically projected region of the surface mount electronic device is disposed, the resin can be easily reliably filled between the nonmetallic inorganic powder constituting the seat portion while leakage of the resin to the surroundings of the seat portion is prevented merely by filling the resin from above.

Since leakage of the resin does not occur and surface mount electronic devices can also be mounted in the surroundings of the seat portion at a high density, high accuracy mounting form can be realized.

Consequently, a highly reliable multilayer ceramic electronic device having excellent impact resistance and excellent compatibility with miniaturization can be provided.

Examples of configuration of the seat portion having a structure in which the resin is filled and being adhered to the first principal surface of the multilayer ceramic element assembly with at least the resin include a seat portion adhered to the first principal surface of the multilayer ceramic element assembly with at least a resin by impregnating an aggregate of the ceramic powder which is a nonmetallic inorganic powder, that is, a porous ceramic compact, with the resin and conducting curing. The aggregate is prepared by heat-treating the unfired ceramic compact disposed on the first principal surface of the multilayer ceramic element assembly so as to volatilize a binder component contained in a sheet and sinter a key portion or a part of the sheet or make the key portion or a part of the sheet into a porous state in which the sheet is substantially not sintered but a predetermined shape is maintained.

In the multilayer ceramic electronic device according to Claim 14, the same resin as that filled into the seat portion can also be filled as an underfill resin into the gap between the surface mount electronic device and the seat portion. Furthermore, a resin of a type different from the type of the resin filled into the seat portion can also be filled as the underfill resin. In the case where the same resin as that filled into the seat portion is filled as an underfill resin, filling of the resin into the seat portion and the gap between the surface mount electronic device and the seat portion can be conducted in one operation by supplying a total amount of the resin required for filling the seat portion and the resin required for filling the gap between the surface mount electronic device and the seat portion from the resin introduction portion of the seat portion.

As in the multilayer ceramic electronic device according to Claim 15, in the case where a structure in which resins having the same composition are filled in the seat portion containing the nonmetallic inorganic powder as a primary component and between the seat portion and the surface mount electronic device, the resins being filled through the resin introduction portion, is employed in the configuration of the invention according to Claim 14, it becomes possible to form a resin layer having high affinity for the resin constituting the seat portion between the surface mount electronic device and the seat portion, and a multilayer ceramic electronic device having excellent impact resistance and exhibiting high reliability can be provided.

As in the multilayer ceramic electronic device according to Claim 16, a configuration in which the surface mount electronic device is electrically connected to the first conductor pattern of the multilayer ceramic element assembly with the second conductor pattern of the seat portion is employed in the configuration of the invention according to Claim 14 or 15 and, thereby, mechanical connection and electrical connection of the surface mount electronic device can be conducted at the same time, so that a small, high-performance, high-reliability multilayer ceramic electronic device can be provided.

### Brief Description of Drawings

[Fig. 1] Fig. 1 is a diagram showing the configuration of a multilayer ceramic electronic device (multilayer ceramic substrate) according to an example of the present invention.
[Fig. 2] Fig. 2 (a) is an exploded perspective view showing a key portion (disposition form of a seat portion on a multilayer ceramic element assembly) of the multilayer ceramic electronic device shown in Fig. 1, and (b) is a perspective view showing a state in which a semiconductor element is mounted on the seat portion.
[Fig. 3] Fig. 3 is a diagram showing one step of a method for manufacturing a multilayer ceramic electronic device according to an example of the present invention.
[Fig. 4] Fig. 4 is a diagram showing another step of a method for manufacturing a multilayer ceramic electronic device according to an example of the present invention.
[Fig. 5] Fig. 5 is a diagram showing another step of a method for manufacturing a multilayer ceramic electronic device according to an example of the present invention.
[Fig. 6] Fig. 6 is a diagram showing another step of a method for manufacturing a multilayer ceramic electronic device according to an example of the present invention.
[Fig. 7] Fig. 7 is a diagram showing another step of a method for manufacturing a multilayer ceramic electronic device according to an example of the present invention.
[Fig. 8] Fig. 8 is a diagram showing another step of a method for manufacturing a multilayer ceramic electronic device according to an example of the present invention.
[Fig. 9] Fig. 9(a) to (e) are diagrams for explaining a method for forming a seat portion constituting a multilayer ceramic electronic device according to an example.
[Fig. 10] Fig. 10 is a diagram showing a multilayer ceramic electronic device according to Comparative example 1 for purposes of comparison of the characteristics of a multilayer ceramic electronic device according to an example of the present invention.
[Fig. 11] Fig. 11 is a diagram showing a multilayer ceramic electronic device according to Comparative example 2 for purposes of comparison of the characteristics of a multilayer ceramic electronic device according to an example of the present invention.
[Fig. 12] Fig. 12 is a diagram schematically showing a sample prepared for the purpose of examining the impact resistance of a multilayer ceramic electronic device produced by a method for manufacturing a multilayer ceramic electronic device according to an example of the present invention.
[Fig. 13] Fig. 13 (a) and (b) are diagrams showing modified examples of the configuration of a seat portion constituting a multilayer ceramic electronic device according to the present invention.
[Fig. 14] Fig. 14 is a diagram showing another modified example of the configuration of a seat portion constituting a multilayer ceramic electronic device according to the present invention.
[Fig. 15] Fig. 15 is a diagram showing a modified example of a disposition form of a surface mount electronic device on a seat portion in a multilayer ceramic electronic device according to the present invention, (a) is a front sectional view, and (b) is a plan view.
[Fig. 16] Fig. 16 is a diagram showing another modified example of a disposition form of a surface mount electronic device on a seat portion in a multilayer ceramic electronic device according to the present invention.
[Fig. 17] Fig. 17 is a diagram showing another modified example of a disposition form of a surface mount electronic device on a seat portion in a multilayer ceramic electronic device according to the present invention.
[Fig. 18] Fig. 18 is a diagram showing a method for mounting a semiconductor device and the like in related art.
[Fig. 19] Fig. 19 is a diagram showing the mounting structure of another semiconductor element in related art.

### Reference Numerals

- 1: first ceramic layer
- 2: second ceramic layer (shrinkage restriction layer)
- 3: internal in-plane conductor
- 4: multilayer ceramic element assembly
- 4a: green sheet compact (unfired multilayer ceramic element assembly)
- 5: external conductor
- 6: terminal electrode
- 7: via hole conductor
- 10: multilayer ceramic substrate
- 11: seat portion
- 11A: resin introduction portion
- 13: semiconductor element (surface mount electronic device)
- 14: upper surface of multilayer ceramic element assembly (first principal surface)
- 15: solder
- 15a: solder paste
- 16: resin layer
- 17: seat portion via hole conductor
- 17a: one end surface (upper end surface)
- 17b: the other end surface
- 21: nonmetallic inorganic powder
- 22: resin
- 23: surface mount electronic device
- 24: resin supply nozzle
- 25: solder ball
- 31: carrier film
- 32: green sheet
- 33: through hole
- 34: electrically conductive paste
- 35: abrasive roll
- 40: printed circuit board
- 41: resin casing
- A, A1, A2: multilayer ceramic electronic device
- R: vertically projected region

### Best Mode for Carrying Out the Invention

The features of the present invention will be described below in further detail with reference to the example of the present invention.

### EXAMPLE 1

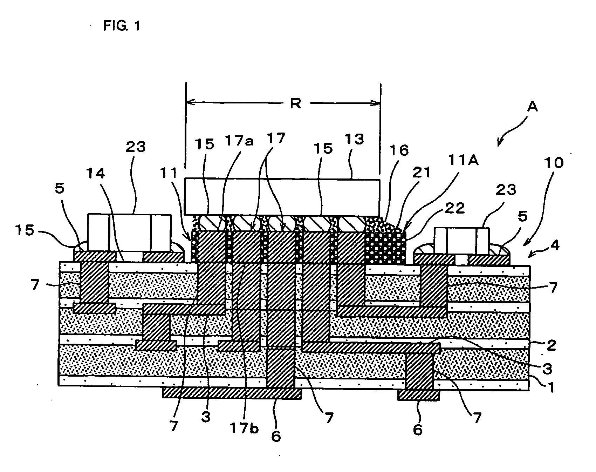

Fig. 1 is a sectional view showing the entire structure of a multilayer ceramic electronic device which is a multilayer ceramic electronic device according to an example of the present invention.

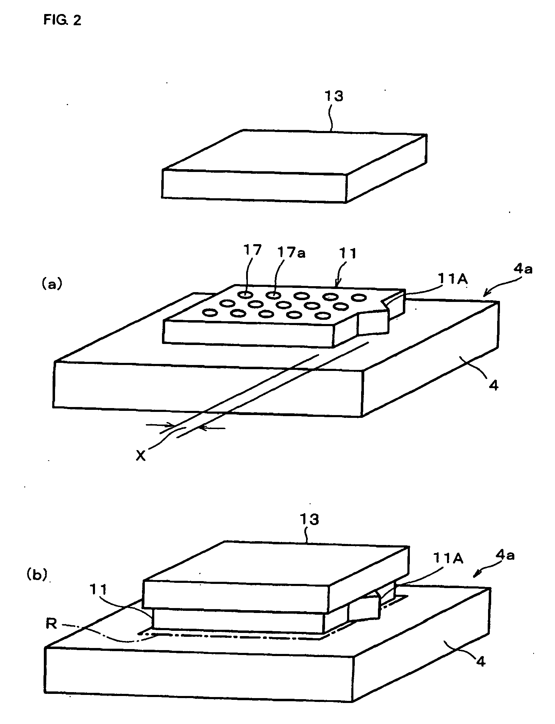

Furthermore, Fig. 2 (a) is an exploded perspective view showing a key portion (disposition form of a seat portion on a multilayer ceramic element assembly) of the multilayer ceramic electronic device shown in Fig. 1, and (b) is a perspective view showing a state in which a semiconductor element is mounted on the seat portion. In Fig. 2 (a) and (b), merely the multilayer ceramic element assembly, the seat portion, and the semiconductor element are shown, and the other devices are omitted.

As shown in Fig. 1 and Fig. 2(a) and (b), a multilayer ceramic electronic device A of Example 1 includes a multilayer ceramic element assembly 4 provided with first ceramic layers 1 serving as ceramic base material layers, second ceramic layers 2 serving as shrinkage restriction layers which are laminated in contact with principal surfaces of the first ceramic layers and which are disposed to restrict shrinkage of the ceramic base material layers in a plane direction in a firing step, and internal in-plane conductors 3 serving as conductor patterns formed between layers of the first ceramic layers 1 and the second ceramic layers 2.

External conductors 5 and terminal electrodes 6 are disposed on the surfaces of the multilayer ceramic element assembly 4. Via hole conductors 7 are disposed in such a way as to penetrate the first ceramic layers 1 and/or second ceramic layers 2. The internal in-plane conductors 3 disposed in different layers, the internal in-plane conductor 3 and the external conductor 5, or the internal in-plane conductor 3 and the terminal electrode 6 are electrically connected to each other with via hole conductor 7 therebetween, if necessary.

The multilayer ceramic electronic device A of Example 1 is provided with a seat portion 11 formed from a material containing nonmetallic inorganic powder 21 and a resin 22, that is, in Example 1, the seat portion 11 in which an aggregate of the nonmetallic inorganic powder 21 is adhered to the first principal surface 14 with the resin 22, in a partial region of an upper surface (first principal surface) 14 of the multilayer ceramic element assembly 4 provided with the first and the second ceramic layers 1 and 2 and internal in-plane conductors 3. The seat portion 11 is provided with the seat portion via hole conductors 17 disposed in such a way that one end surface (upper end surface) 17a of the seat portion via hole conductor 17 is exposed at the upper surface side of the seat portion 11 and the other end surface 17b is connected to the internal in-plane conductor 3 with a via hole conductor 7 disposed in the multilayer ceramic element assembly 4 therebetween.

In Example 1, the internal in-plane conductors 3, the external conductors 5, the via hole conductors 7, and the like, which are disposed in the multilayer ceramic element assembly 4, constitute the first conductor pattern in the present invention. The seat portion via hole conductors 17 disposed in the seat portion constitute the second conductor pattern in the present invention.

It is desirable that the diameter of the seat portion via hole conductor 17 disposed in the seat portion 11 is specified to be within the range of 30 to 120 µm.

A semiconductor element 13 serving as a surface mount electronic device is disposed on the seat portion 11. The semiconductor element 13 is electrically connected to the seat portion via hole conductors 17 disposed in the seat portion with solder 15 serving as an electrically conductive jointing member therebetween.

Furthermore, a resin layer 16 filled with a resin 22 having the same composition as the resin 22 used for the seat portion 11 is disposed in the gap between the seat portion 11 and the semiconductor element 13.

In the seat portion constituting the multilayer ceramic electronic device A, as shown in Fig. 2 (a) and (b), a resin introduction portion 11A located outside a vertically projected region R of the surface mount electronic device (semiconductor element) 13 is disposed. In Example 1, a protrusion portion is disposed as the resin introduction portion 11A in such a way as to protrude from one side of the seat portion 11 to the outside of the vertically projected region R of the semiconductor element 13.

The resin 22 filling the seat portion 11 has been filled into the seat portion 11 through this resin introduction portion 11A. The resin layer 16 disposed between the seat portion 11 and the semiconductor element 13 is formed also by filling the resin 22 from this resin introduction portion 11A.

Preferably, the thickness of the seat portion 11 is specified to be a thickness which becomes within the range of 15 to 150 µm after firing, and more preferably within the range of 30 to 100 µm.

In the multilayer ceramic electronic device A of Example 1, the first ceramic layer 1 is formed by sintering a first ceramic material and substantially dominates the substrate characteristics of the multilayer ceramic substrate 10. Preferably, the thickness of this first ceramic layer 1 is within the range of 8 µm to 100 µm after firing. The thickness of the first ceramic layer 1 is not necessarily limited to the above-described range. However, it is preferable that the thickness is specified to be smaller than or equal to the thickness at which shrinkage can be restricted by the shrinkage restriction layer (that is, the second ceramic layer) 2. The thicknesses of all first ceramic layers 1 are not necessarily the same.

As for the first ceramic material, a material, a part of which (for example, glass component) penetrates the second ceramic layer 2 during firing, is used. As for the first ceramic material, it is preferable to use LTCC (Low Temperature Co-fired Ceramic) which can be fired at relatively low temperatures, e.g., 1,050°C or lower in order that co-firing with a conductor composed of a low melting point metal, e.g., silver or copper, can be conducted. Specifically, glass ceramic in which alumina and borosilicate glass are mixed, Ba-Al-Si-B oxide ceramic which generates a glass component during firing, and the like can be used.

In the case where the first ceramic material contains a low-temperature-sinterable ceramic raw material powder as a primary component, main constituent materials for the via hole conductor 7, the seat portion via hole conductor 17, the internal in-plane conductor 3, and the like can be selected from metals and alloys containing at least one type selected from the group consisting of Ag, Au, and Cu having excellent high-frequency characteristics as a primary component. This alloy may contain Pd, W, Ni, and the like.

The second ceramic material constituting the shrinkage restriction layer (that is, second ceramic layer) 2 is adhered by a part of the first ceramic material (glass component) which has penetrated from the first ceramic layer 1. Consequently, the first ceramic layer 1 and the second ceramic layer 2 are bonded as the second ceramic layer is solidified.

As for the second ceramic material constituting this shrinkage restriction layer (that is, second ceramic layer) 2, alumina, zirconia, silica, and the like can be used. The second ceramic layer 2 contains the unsintered second ceramic material having a sintering temperature higher than that of the first ceramic material and, therefore, the second ceramic layer 2 exerts a function of restricting shrinkage of the first ceramic layer 1 in a plane direction during a firing process. Furthermore, as described above, the second ceramic layer 2 is adhered and bonded to the first ceramic layer 1 by the penetration of a part of the first ceramic material. Therefore, preferably, the thickness of the second ceramic layer 2 after firing is within the range of 1 to 10 µm, and further preferably within the range of 2 to 7 µm, although depending on the states of the first ceramic layer 1 and the second ceramic layer 2, a binding force, and a firing condition in a strict sense.

The second ceramic layer 2 may contain a glass component serving as an adhesion member of the second ceramic layer within the bounds of no occurrence of shrinkage behavior of the second ceramic layer 2 during firing. As for this glass component, it is desirable that glass having substantially the same composition as that of a glass component added to the first ceramic layer 1 or a glass component generated in the first ceramic layer 1 during firing.

In Example 1, a Ba-Al-Si-B oxide ceramic material was used for the first ceramic layer 1, and alumina was used as the ceramic material constituting the second ceramic layer 2. The thickness of the first ceramic layer 1 was adjusted to become 50 µm after firing, and the thickness of the second ceramic layer 2 was adjusted to become 5 µm after firing.

Regarding each of the conductor portions, e.g., the internal in-plane conductor 3, the external conductor 5, and the terminal electrode 6, if an electrically conductive component co-sinterable with the first ceramic layer 1 is contained as a primary component, various known materials can be used. Specifically, Cu, Ag, Ni, Pd, and alloys thereof can be used. In Example 1, conductor portions were formed by using a material primarily containing a Cu component (for example, an electrically conductive paste containing a Cu powder as an electrically conductive component).

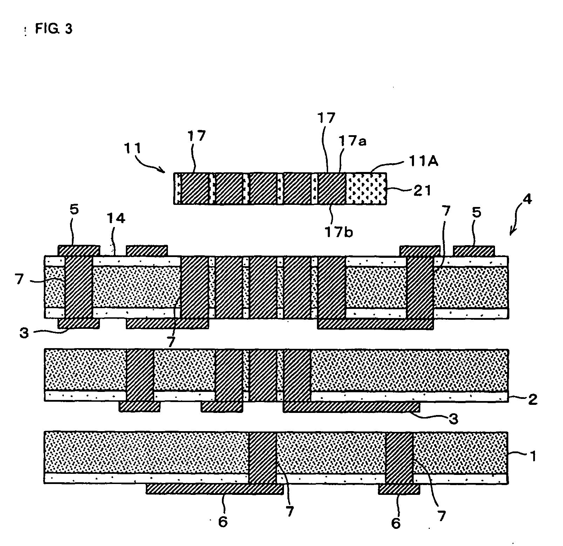

Next, a method for manufacturing the multilayer ceramic electronic device A of Example 1 will be described.
(1) As shown in Fig. 3, an electrically conductive paste containing a Cu powder as an electrically conductive component is printed at predetermined positions of ceramic green sheets serving as the first ceramic layers 1 and the second ceramic layers 2 and, thereby, the internal in-plane conductors 3, the external conductors 5, the via hole conductors 7, and the like are disposed.
(2) As for the seat portion 11, a green sheet containing a nonmetallic inorganic powder 21 (for example, a ceramic powder, e.g., alumina, zirconia, or GaN), which is not sintered at a firing temperature of the first ceramic material, as a primary component is prepared, the green sheets being provided with via hole conductors (seat portion via hole conductors) 17 containing, for example, Ag or Cu as a primary component.

As shown in Fig. 1 and Fig. 2(a) and (b), the seat portion 11 is provided with the resin introduction portion 11A located outside a vertically projected region R of the semiconductor element (surface mount electronic device) 13 mounted on the seat portion 11.

In Example 1, a protrusion portion formed in such a way as to protrude from one side to the outside of the vertically projected region R of the semiconductor element 13 is allowed to serve as the resin introduction portion 11A of the seat portion 11.

The thickness of the seat portion 11 is specified to become within the range of 15 to 150 µm after firing.

The seat portion 11 (seat portion before firing) can be produced by, for example, a method as described below.

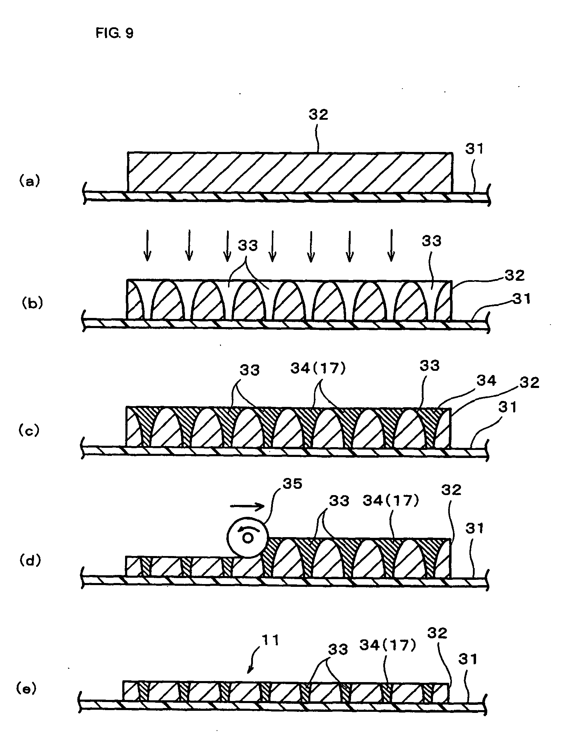

As shown in Fig. 9 (a), a green sheet for forming the seat portion, for example, a green sheet 32 containing a nonmetallic inorganic powder (for example, a ceramic powder, e.g., alumina, zirconia, or GaN), which is not sintered at a firing temperature of the first ceramic material, as a primary component is formed on a carrier film 31. Thereafter, as shown in Fig. 9 (b), for example, through holes 33 for disposing via hole conductors are formed at predetermined positions of the green sheet 32 by a laser beam machining method. In Example 1, a green sheet primarily containing alumina was used as the green sheet for forming the seat portion.

As shown in Fig. 9 (c), the through holes 33 are filled with an electrically conductive paste 34.

If the state shown in Fig. 9 (c) remains on an "as is" basis, the electrically conductive paste 34 filled in the individual through holes 33 may short-circuit. Therefore, as shown in Fig. 9 (d), a surface of the green sheet 32 is ground with an abrasive roll 35 so as to remove the electrically conductive paste 34 covering the surface and a part of the green sheet 32 on the upper surface side and, in addition, flatten the upper surface. In this manner, as shown in Fig. 9 (e), the seat portion (unfired seat portion) 11 having a flat upper surface, no fear of short circuit, and via hole conductors (seat portion via hole conductors 17) with a narrow pitch is formed.

The unfired seat portion 11 is placed on a first principal surface 14 of the unfired multilayer ceramic element assembly 4 in such a way that the upper surface shown in Fig. 9 (e) is bonded to the first principal surface 14 of the multilayer ceramic element assembly 4, and the carrier film 31 (Fig. 9 (e)) is removed, so that a state in which the seat portion 11 is disposed at the predetermined position of the unfired multilayer ceramic element assembly 4 can be brought about.

Alternatively, a lower surface of the unfired seat portion 11 (the side of the carrier film 31) may be bonded to the first principal surface 14 of the multilayer ceramic element assembly 4. For example, although not specifically shown in the drawing, it is also possible to employ a configuration in which the unfired seat portion 11 is held on a holding table while the surface not provided with the carrier film 31 is allowed to face the table, the carrier film 31 is removed and, thereafter, the unfired multilayer ceramic element assembly 4 is formed on the surface, from which the carrier film 31 has been removed.

A ceramic green sheet formed from the same ceramic material as the ceramic material constituting the second ceramic layer can also be used as a green sheet for forming the seat portion.

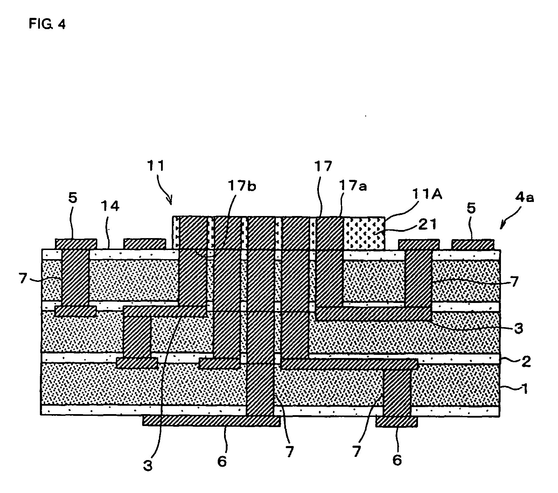

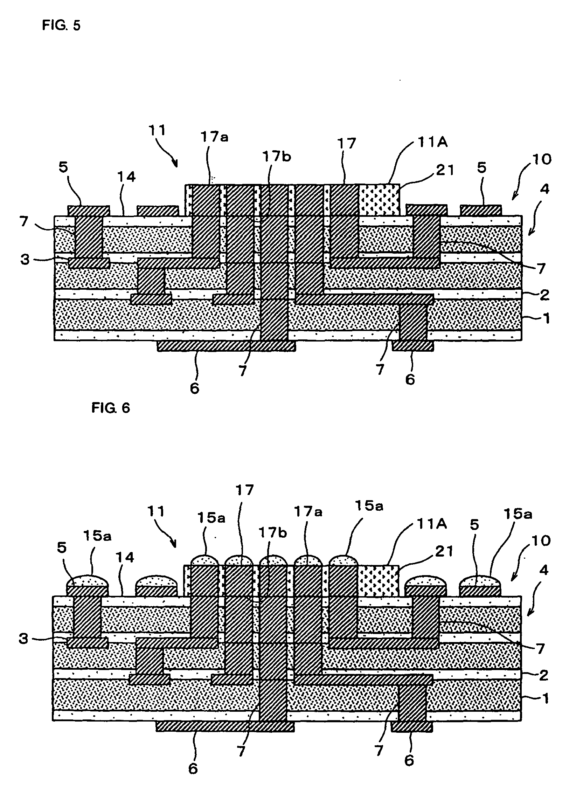

It is also possible to use various ceramic green sheets having compositions different from the ceramic material constituting the second ceramic layer.
(3) The ceramic green sheets and the seat portion obtained in the steps of the above-described items (1) and (2) are laminated and press-bonded following the predetermined order and direction, as shown in Fig. 4, so that a seat-portion-equipped green sheet compact (unfired seat-portion-equipped multilayer ceramic element assembly) 4a is formed.
(4) The above-described unfired seat-portion-equipped multilayer ceramic element assembly 4a (refer to Fig. 4) is fired under a condition controlled at predetermined temperature and atmosphere and, thereby, the multilayer ceramic substrate 10 provided with the seat portion 11 on the upper surface (first principal surface) 14 of the multilayer ceramic element assembly 4 is obtained (refer to Fig. 5). In this state, the seat portion 11 is present as a porous compact in which ceramic particles are aggregated.

At this time, the multilayer ceramic element assembly 4 is fired at a temperature at which the first ceramic material constituting the multilayer ceramic element assembly 4 is sintered and the second ceramic material constituting the multilayer ceramic element assembly 4 is not sintered. Consequently, when the first ceramic layer 1 composed of the first ceramic material is going to shrink, the second ceramic layer 2 serving as a shrinkage restriction layer, which is composed of the second ceramic material, performs the function of restricting the shrinkage of the first ceramic layer 1. In this manner, the multilayer ceramic substrate 10 with high dimensional accuracy can be produced. When firing is conducted by the method as in Example 1, the multilayer ceramic element assembly 4 can be fired in such a way as to shrink in a thickness direction (shrink to about 45% to 65% of the thickness in the unfired state) but almost not shrink in a plane direction orthogonal to the thickness direction.

The firing atmosphere is adjusted appropriately in accordance with the type of the first ceramic material, the type of electrically conductive powder contained in the electrically conductive paste film, and the like. In the present example, the firing was conducted substantially in a reducing atmosphere at a maximum firing temperature of 950°C to 1,000°C.
(5) The resulting multilayer ceramic substrate 10 is subjected to a surface treatment, if necessary, and thereafter, the surface mount electronic devices are mounted.

Various surface mount electronic devices can be mounted in accordance with the circuit to be formed. Specific examples include active elements e.g., transistors, ICs, and LSIs, and passive elements, e.g., chip capacitors, chip resistances, chip thermistors, and chip inductors.

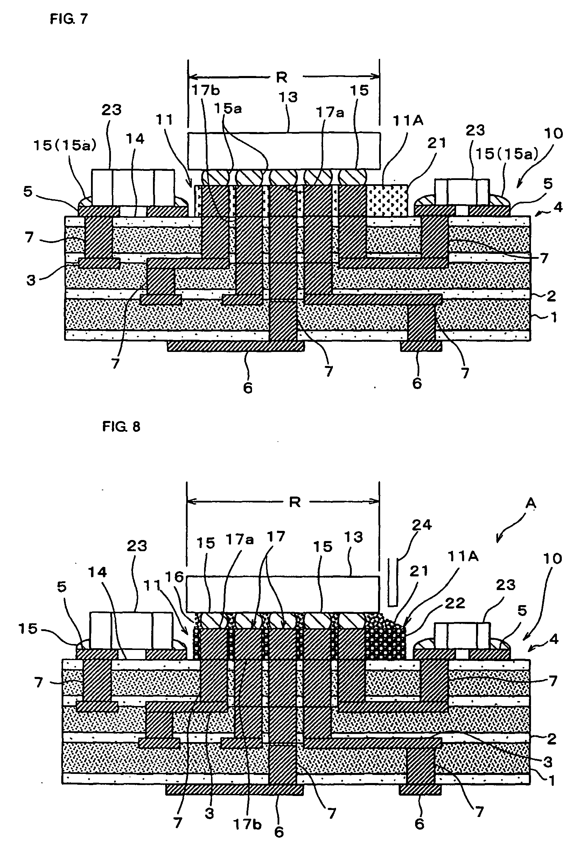

In Example 1, in particular, the case where semiconductor elements, e.g., ICs and LSIs, are mounted is described as an example.
(5-1) As shown in Fig. 6, a solder paste 15a is applied to the upper end surfaces 17a of the seat portion via hole conductors 17. The application method is not specifically limited, and various known methods, e.g., printing, dipping, and dispensing, can be used.
   At this time, the solder paste 15a is also applied to external conductors 5 which are disposed on regions not provided with the seat portion 11 in the first principal surface 14 of the multilayer ceramic element assembly 4 and which are for mounting the other surface mount electronic devices (monolithic ceramic capacitor and the like) 23.
(5-2) Thereafter, as shown in Fig. 7, the semiconductor element 13 is mounted on the solder paste 15a, and the other surface mount electronic devices (monolithic ceramic capacitor and the like) 23 are mounted on regions not provided with the seat portion 11 in the upper surface (first principal surface) 14 of the multilayer ceramic element assembly 4. The solder paste 15a is melted and solidified in a reflow furnace set at a predetermined temperature profile, so that the semiconductor element 13 is bonded to the upper end surfaces 17a of the seat portion via hole conductors 17 and, in addition, the other surface mount electronic devices 23 are connected to the external conductors 5 disposed in regions surrounding the region provided with the seat portion 11 in the first principal surface 14 of the multilayer ceramic element assembly 4.
(5-3) As shown in Fig. 8, the resin 22 is injected between the semiconductor element 13 and the seat portion 11, so that the resin layer 16 is formed between the semiconductor element 13 and the seat portion 11 and, in addition, the resin 22 is allowed to penetrate up to the lower surface side of the porous ceramic compact constituting the seat portion 11.

The injection of the resin 22 is conducted by supplying the resin 22 from a resin supply nozzle 24 to the resin introduction portion 11A of the seat portion 11. At this time, since the resin introduction portion 11A is located outside the vertically projected region R of the semiconductor element 13 mounted on the seat portion 11, the resin 22 is allowed to penetrate throughout the porous ceramic compact until the lower surface side is reached and, in addition, the resin 22 is filled between the semiconductor element 13 and the seat portion 11, so that the resin layer 16 can be formed, merely by supplying the resin 22 to the resin introduction portion 11A from above.

The resin 22 penetrates and infiltrates selectively into the porous seat portion 11 and between the semiconductor element 13 and the seat portion 11 through capillarity. Therefore, the resin 22 substantially hardly leak to the other regions after the filling.

Subsequently, the resin 22 is heat-cured so as to adhere the seat portion 11 to the first principal surface 14 of the multilayer ceramic element assembly 4 with the resin 22. Regarding the resin used in Example 1, 65 percent by weight of silica filler was contained and the remainder was a mixture of an epoxy resin and a solvent.

The amounts of the epoxy resin and the solvent may be changed in accordance with the thickness of the seat portion.

In this manner, the multilayer ceramic electronic device A is formed, wherein the semiconductor element 13 is mounted on the seat portion 11 in the state in which the aggregate of the nonmetallic inorganic powder 21 is adhered to a partial region of the first principal surface region 14 of the multilayer ceramic element assembly 4 with the resin 22.

In this multilayer ceramic electronic device A, the seat portion 11 is provided with the resin introduction portion 11A located outside the vertically projected region R of the semiconductor element 13 mounted on the seat portion 11. Therefore, the resin 22 is allowed to penetrate until the lower surface side of the porous ceramic compact constituting the seat portion 11 is reached and, in addition, the resin layer 16 can be formed between the semiconductor element 13 and the seat portion 11 merely by supplying the resin 22 to the resin introduction portion 11A from above without need for a complicated resin supply mechanism and the like.

The seat portion 11 is composed of the aggregate of the ceramic powder, the silica filler, and the resin adhering these inorganic components to each other, and the resin layer 16 in the state in which the silica filler is dispersed is formed between the seat portion 11 and the semiconductor element 13.

Therefore, the semiconductor element 13 is mechanically connected and fixed to the multilayer ceramic element assembly 4 (multilayer ceramic substrate 10) with the seat portion 11 therebetween by the resin layer 16 and, in addition, the semiconductor element 13 is mechanically electrically connected to the multilayer ceramic element assembly 4 (multilayer ceramic substrate 10) reliably with the seat portion via hole conductors 17 and the solder 15 therebetween. Consequently, the highly reliable multilayer ceramic electronic device A having excellent impact resistance, excellent compatibility with miniaturization, and good dimensional accuracy can be obtained.

Furthermore, the seat portion 11 is provided with the resin introduction portion 11A located outside the vertically projected region R of the semiconductor element 13 mounted on the seat portion 11. Therefore, the resin 22 is allowed to penetrate until the lower surface side of the porous ceramic compact constituting the seat portion 11 is reached and, in addition, the resin layer 16 can be formed between the semiconductor element 13 and the seat portion 11 merely by supplying the resin 22 to the resin introduction portion 11A from above without need for a complicated resin supply mechanism and the like. Consequently, the multilayer ceramic electronic device A in which the seat portion 11 is adhered to the multilayer ceramic element assembly 4 reliably and the semiconductor element 13 is firmly bonded to and mounted on the seat portion 11 can be produced efficiently.

### [Characteristics evaluation 1: characteristics evaluation with respect to leakage of resin]

Regarding the multilayer ceramic electronic device in which the seat portion 11 is provided with the resin introduction portion 11A as in the above-described Example 1, a state of leakage of the resin 22 (resin layer 16) filled in the seat portion 11 and between the seat portion 11 and the semiconductor element 13 was examined.

For the purposes of comparison, multilayer ceramic electronic devices of comparative examples were prepared as described below. Regarding these multilayer ceramic electronic devices (Comparative example 1 and Comparative example 2) as well, a state of leakage of the resin 22 (resin layer 16) filled in the seat portion 11 and between the seat portion 11 and the semiconductor element 13 was examined.

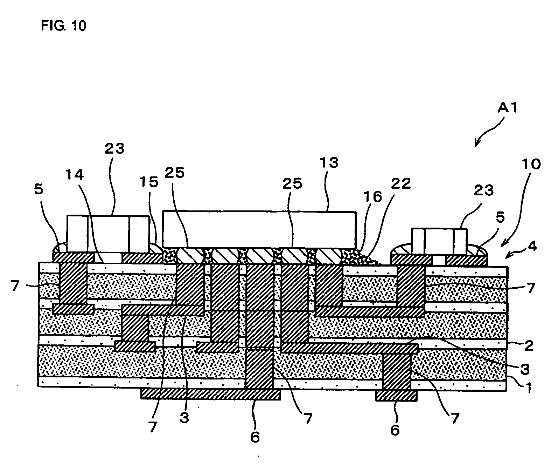

As for Comparative example 1, a multilayer ceramic electronic device A1 was prepared having a structure, as shown in Fig. 10, in which solder balls 25 disposed on the semiconductor element 13 were melt-bonded to the surface of via hole conductors 7 exposed at the multilayer ceramic element assembly 4, the resin layer 16 for functioning as an impact relaxation layer and a bonding layer was formed by filling the thermosetting resin 22 (the same resin as the resin 22 used in the multilayer ceramic electronic device A in the above-described Example 1) between the multilayer ceramic element assembly 4 and the semiconductor element 13 in order to improve the impact resistance, and the seat portion included in the multilayer ceramic electronic device A in the present invention is not provided.

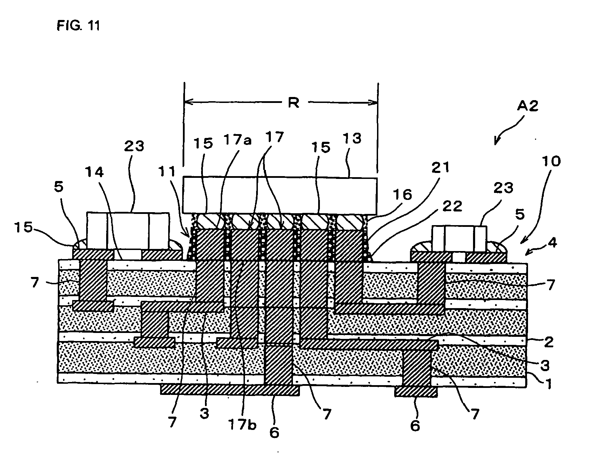

As for Comparative example 2, a multilayer ceramic electronic device A2 was prepared having a structure, as shown in Fig. 11, in which a resin introduction portion was not disposed, the seat portion 11 was provided while the entire seat portion 11 was located within the vertically projected region R of the semiconductor element 13 mounted thereon, the resin 22 was filled in the seat portion 11 and between the seat portion 11 and the semiconductor element 13, and the resin layer 16 for functioning as an impact relaxation layer and a bonding layer was formed.

Regarding each of the multilayer ceramic electronic device A of the above-described Example 1 and multilayer ceramic electronic devices A1 and A2 of Comparative examples 1 and 2, the mounting height of the semiconductor element 13 (solder height of the lower portion of the semiconductor element 13 after mounting) was specified to be about 60 µm.

Regarding the multilayer ceramic electronic device A of Example 1 and the multilayer ceramic electronic device A2 of Comparative example 2, the perimeter edge portion of the seat portion 11 located within the vertically projected region R of the semiconductor element 13 was positioned about 100 µm inside the perimeter edge portion of the semiconductor element 13.

Regarding the multilayer ceramic electronic device A of Example 1, the protrusion distance X (refer to Fig. 2 (a)) of the resin introduction portion 11A, which was located outside the vertically projected region R of the semiconductor element 13, of the seat portion 11 from the side on which the resin introduction portion 11A was formed, was set at about 1 mm.

Injection of the resin was conducted by using a resin supply nozzle having a diameter of 0.5 mm, and regarding the multilayer ceramic electronic device A of Example 1, the resin 22 was supplied from the upper surface of the resin introduction portion 11A of the seat portion 11.

In Comparative example 1, the resin 22 was injected into the gap between the multilayer ceramic element assembly 4 and the semiconductor element 13 from the position at a distance of 0.5 mm from the side surface of the semiconductor element 13, so as to form the resin layer 16 between the multilayer ceramic element assembly 4 and the semiconductor element 13.

In Comparative example 2, the resin 22 was supplied to the side surface of the seat portion 11 from the position at a distance of 0.5 mm from the side surface of the semiconductor element 13, so as to fill the seat portion 11 with the resin 22.

Regarding the multilayer ceramic electronic devices A, A1, and A2 of Example 1 and Comparative examples 1 and 2, the leakage length of the resin 22 from the edge portion of the semiconductor element 13 was measured.

As a result, regarding the multilayer ceramic electronic device A1 of Comparative example 1, about 400 µm of leakage length of the resin 22 was observed, and regarding the multilayer ceramic electronic device A2 of Comparative example 2, about 500 µm of leakage length was observed. Variations in leakage states thereof were significant, and it was ascertained that large design margins were required although statistical prediction was possible.

On the other hand, regarding the multilayer ceramic electronic device A of Example 1, it was ascertained that there was no leakage of the resin 22 from any position of the seat portion 11 and regarding three sides, at which the resin introduction portion 11A was not disposed, of the seat portion 11, the resin 22 was held inside the vertically projected region R of the semiconductor element 13.

Furthermore, it was ascertained that although the resin introduction portion 11A itself extended off the vertically projected region R of the semiconductor element 13, the resin did not leak to the outside of the resin introduction portion 11A, merely consideration of the design margin of the resin introduction portion 11A was required and, therefore, the application region of the resin was predicted easily.

As described above, the injection resin contained 65 percent by weight of silica filler and the remainder was an organic mixture of an epoxy resin, a solvent, and the like. However, in the case where the resin containing 30 percent by weight of silica filler and the remainder composed of an organic mixture of an acrylic resin, a solvent, and the like was used as well, leakage of the resin was not observed.

In the present invention, the type and the composition of the resin is not specifically limited, and other types of resins and fillers can be used. Regarding the blend ratio thereof, it is possible to determine optionally in consideration of the production condition and the like.

### [Characteristics evaluation 2: evaluation of impact resistance]

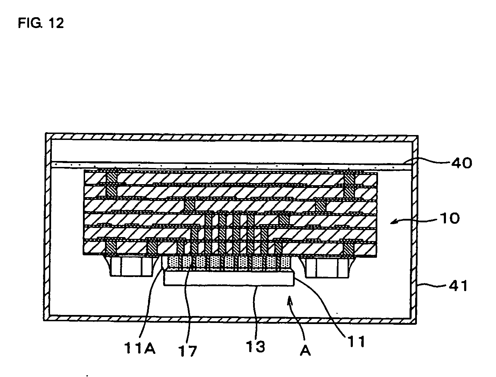

As shown in Fig. 12, the multilayer ceramic electronic device A of Example 1 prepared as described above was mounted on a printed circuit board 40 having a thickness of 1.0 mm through reflow by using a solder paste and, thereafter, the multilayer ceramic electronic device A mounted on the printed circuit board 40 was held in a substantially rectangular parallelepiped casing 41 in such a way that the multilayer ceramic electronic device A was located on the lower surface side, so that a sample having a structure in which the multilayer ceramic electronic device A was held in the resin casing 41 was prepared.

The sample was adjusted in such a way that a total weight of the multilayer ceramic electronic device A, the printed circuit board 40, and the resin casing 41 became about 100 g.

The diameter of the seat portion via hole conductor 17 constituting the multilayer ceramic substrate 10 was set at 100 µm.

The resulting sample was held at a predetermined height, and was dropped 10 times while the lower surface of the resin casing 41 in a horizontal position was collided with a concrete block stood in such a way that the upper surface became in a horizontal position. Thereafter, the state of breakage of connection portion of the semiconductor element 13 and the multilayer ceramic substrate 10 was examined.

The drop height was increased stepwise by 0.10 m from 0.50 m, and the impact resistance was evaluated, where the drop height at which breakage occurred was taken as a height of breakage occurrence. The results thereof are shown in Table 1.

**[Table 1]**

| Sample No. | Height of breakage occurrence (m) | Solder height of lower side of seat portion (µm) | Leakage of resin | Impact resistance |
|---|---|---|---|---|
| 1 (Example) | 1.50 | 60 | no leakage | good |
| 2 (Comparative example 1) | 0.8 | 60 | leakage | poor |
| 3 (Comparative example 2) | 1.50 | 60 | no leakage | good |

For the purposes of comparison, samples (Comparative examples) were prepared by mounting the above-described multilayer ceramic electronic devices A1 and A2 of Comparative examples 1 and 2 shown in Fig. 10 and Fig. 11 on printed circuit boards, followed by holding in resin casings, and the impact resistance was evaluated as in the above-described Example 1.

As a result, regarding the samples by using the multilayer ceramic electronic device A of the present invention provided with the seat portion and the multilayer ceramic electronic device A2 of Comparative example 2, it was ascertained that breakage did not occur until the drop height reached 1.5 m and, therefore, good impact resistance was ensured.

Regarding Comparative example 2, the impact resistance is ensured, but as described above, leakage of the resin is observed. Therefore, in order to meet high-density mounting and the like satisfactorily, it is necessary to use complicated filling equipment for filling the resin or devise a specific filling method.

On the other hand, regarding Comparative example 1 not provided with the seat portion 11, it was ascertained that breakage occurred when the drop height reached 0.8 m and, therefore, the impact resistance was unsatisfactory.

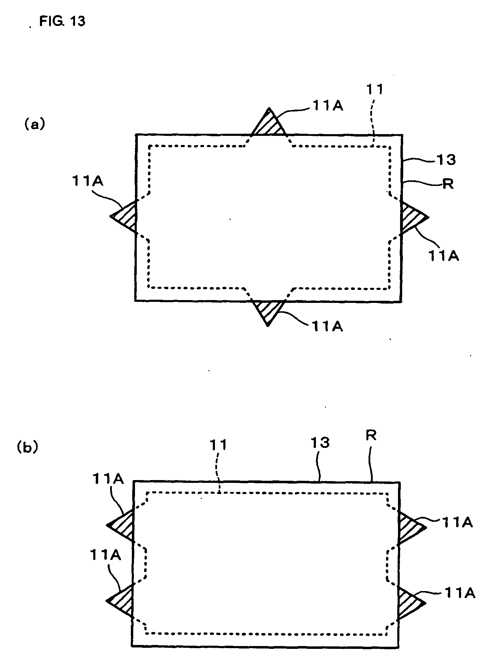

In the above-described Example 1, the multilayer ceramic electronic device A in which the resin introduction portion 11A was formed on merely one side of the seat portion 11 has been described as an example. However, as shown in Fig. 13 (a), the resin introduction portions 11A can also be formed on a plurality of sides of the seat portion 11. Furthermore, as shown in Fig. 13 (b), a plurality of resin introduction portions 11A can also be formed on one side. Alternatively, the resin introduction portion may be disposed at one or more corner portions.

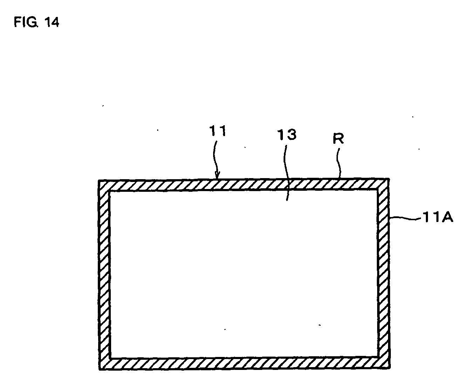

In the case where no problem is caused by extension of the seat portion to the surroundings of the vertically projected region R of the surface mount electronic device, e.g., the semiconductor element, it is also possible that as shown in Fig. 14, the two-dimensional area of the seat portion 11 is allowed to increase, the perimeter portion of the seat portion 11 is extended off the vertically projected region R of the surface mount electronic device 13, and the extended portion of the seat portion 11 is allowed to serve as the resin introduction portion 11A. In this case, it is needless to say that the present invention has the advantage over Comparative examples in the point that variations in length of the extended portion are reduced.

In the present invention, the shape and the configuration of the resin introduction portion of the seat portion are not specifically limited, and various shapes and disposition forms can be adopted within the bounds of not impairing the operation of the present invention.

In the above-described Example 1, the case where the two-dimensional shape of the seat portion 11 except the resin introduction portion 11A is a rectangle has been described as an example. However, the shape of the seat portion 11 is not limited to a rectangle and it is possible to take the shape of a triangle, a polygon more than or equal to pentagon, a circle, or other various shapes regardless of the shape of the surface mount electronic device.

Furthermore, in the above-described Example 1, the case where one semiconductor element is mounted on one seat portion has been described as an example. However, it is also possible to employ a configuration in which a plurality of semiconductor elements are disposed on one seat portion.

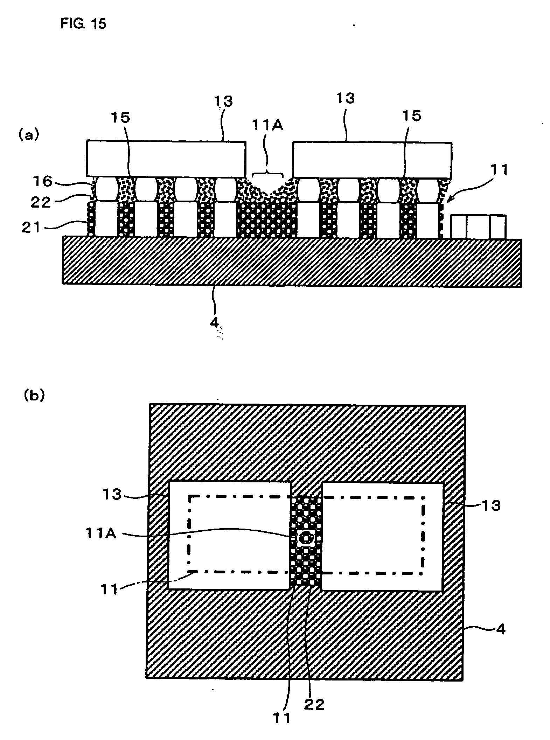

Fig. 15 (a) and (b) are diagrams showing a state in which two semiconductor elements (surface mount electronic devices) 13 are disposed on one seat portion 11. In this example, a part of the seat portion 11 is exposed at between the two semiconductor elements 13, the part serving as the resin introduction portion 11A, the resin 22 is supplied to this one resin introduction portion 11A and, thereby, the resin 22 is filled into the seat portion 11 and the gaps between the seat portion 11 and the two semiconductor elements 13.

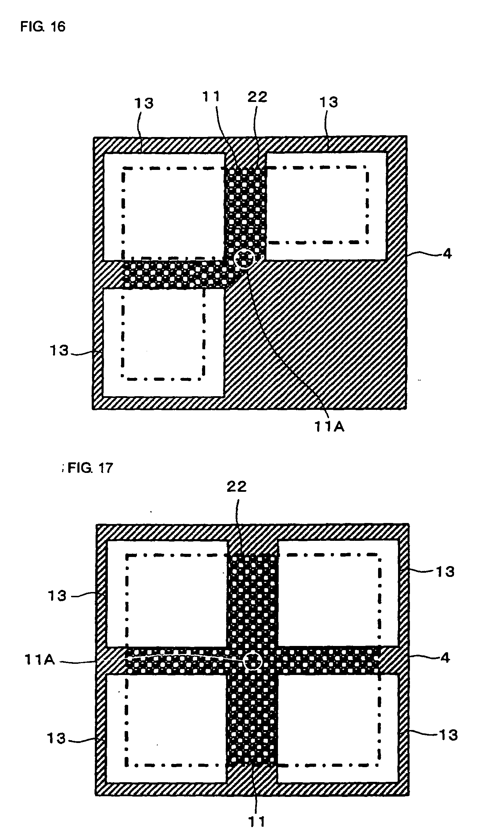

Fig. 16 shows a configuration in which three semiconductor elements (surface mount electronic devices) 13 are mounted on one seat portion 11. Fig. 17 shows a configuration in which four semiconductor elements (surface mount electronic devices) 13 are mounted on one seat portion 11. In the configurations shown in Fig. 16 and Fig. 17 as well, for example, a predetermined one region of the seat portion 11 is allowed to serve as the resin introduction portion 11A, the resin is supplied therefrom and, thereby, the resin 22 can be fill into the seat portion 11 and the gaps between the seat portion 11 and the plurality of semiconductor elements 13. However, it is possible to employ a configuration in which a plurality of resin introduction portions are disposed.

In the above-described Example 1, the method in which the seat portion via hole conductors 17 and the semiconductor element 13 are electrically connected by using a solder paste has been described as an example. However, it is also possible to employ a configuration in which solder balls are disposed instead of the solder paste on the semiconductor element 13 in advance, and the seat portion via hole conductors 17 and the semiconductor element 13 are bonded by melting the solder balls.

Regarding other points as well, the present invention is not limited to the above-described example. Regarding the types of the nonmetallic inorganic powder constituting the seat portion and the resin, the disposition form, the dimension, and the types of the constituent materials of the via hole conductors disposed in the seat portion, the constituent materials and the compositions of the ceramic base material layer and the shrinkage restriction layer, the types of the surface mount electronic device mounted on the seat portion, and the like, various applications and modifications can be made within the scope of the present invention.

### Industrial Applicability

According to the present invention, a seat portion, on which a surface mount electronic device, e.g., a semiconductor element, is mounted, is adhered to a multilayer ceramic element assembly reliably, and a highly reliable multilayer ceramic electronic device having excellent impact resistance, excellent compatibility with miniaturization, and good dimensional accuracy can be produced efficiently.

Therefore, the present invention can be applied widely to multilayer ceramic electronic devices in which semiconductor elements and other surface mount electronic devices are mounted on multilayer ceramic substrates and a field of production thereof.

## Claims

1. A method for manufacturing a multilayer ceramic electronic device in which a surface mount electronic device (13) is mounted on a first principal surface (14) of a multilayer ceramic element assembly (4), the method **characterized by** comprising the steps of:
(a) preparing an unfired seat-portion-equipped multilayer ceramic element assembly provided with
an unfired multilayer ceramic element assembly (4a) in which unsintered ceramic base material layers (1) are laminated and a predetermined first conductor pattern (7) is disposed and
a seat portion (11) for mounting the surface mount electronic device (13), the seat portion (11) being disposed in at least a partial region of the first principal surface (14) of the multilayer ceramic element assembly (4), containing a nonmetallic inorganic powder (21) as a primary component, having a second conductor pattern (17) connected to the surface mount electronic device (13), and having a resin introduction portion (11A) located outside a vertically projected region (R) of the surface mount electronic device (13);
(b) firing the unfired seat-portion-equipped multilayer ceramic element assembly;
(c) mounting the surface mount electronic device (13) on the seat portion (11) of the fired seat-portion-equipped multilayer ceramic element assembly with the second conductor pattern (17) therebetween; and
(d) filling a resin (22) from the resin introduction portion (11A) into the seat portion (11) containing the nonmetallic inorganic powder (21) as the primary component and between the seat portion (11) and the surface mount electronic device (13) and conducting curing.

2. The method for manufacturing a multilayer ceramic electronic device according to Claim 1, **characterized in that** the seat portion (11) containing the nonmetallic inorganic powder (21) as the primary component is formed from a porous ceramic compact.

3. The method for manufacturing a multilayer ceramic electronic device according to Claim 1 or Claim 2, **characterized in that** the unsintered ceramic base material layers (1) and shrinkage restriction layers (2) for restricting shrinkage of the unsintered ceramic base material layers (1) in a plane direction are laminated so as to form the unfired multilayer ceramic element assembly (4a).

4. The method for manufacturing a multilayer ceramic electronic device according to any one of Claims 1 to 3, **characterized in that** the seat portion (11) is provided with via hole conductors as the second conductor pattern (17) while one end surface of each via hole conductor is exposed at the surface of the seat portion (11), and the surface mount electronic device (13) is mounted on the one end surface of each via hole conductor exposed at the surface with an electrically conductive jointing member therebetween.

5. The method for manufacturing a multilayer ceramic electronic device according to any one of Claims 1 to 4, **characterized in that** the second conductor pattern (17) of the seat portion (11) connects the surface mount electronic device (13) mounted on the seat portion (11) and the first conductor pattern (7) of the multilayer ceramic element assembly (4).

6. The method for manufacturing a multilayer ceramic electronic device according to any one of Claims 1 to 5, **characterized in that** the surface mount electronic device (13) comprises a semiconductor element.

7. The method for manufacturing a multilayer ceramic electronic device according to any one of Claims 1 to 6, **characterized in that** in the case where a plurality of surface mount electronic devices (13) are mounted on the seat portion (11), a resin introduction portion (11A) common to individual surface mount electronic devices (13) is disposed on the seat portion (11), the resin (22) is filled from the common resin introduction portion (11A) so as to fill the resin (22) into the seat portion (11) and between the seat portion (11) and the plurality of surface mount electronic devices (13).

8. The method for manufacturing a multilayer ceramic electronic device according to any one of Claims 1 to 7, **characterized in that** surface mount electronic devices (15) other than the surface mount electronic device (13) mounted on the seat portion (11) are mounted on regions, in which the seat portion (11) is not disposed, of the first principal surface (14) of the multilayer ceramic element assembly (4).

9. The method for manufacturing a multilayer ceramic electronic device according to any one of Claims 3 to 8, **characterized in that** an unfired multilayer ceramic element assembly (4a) having a structure in which the shrinkage restriction layer (2) is disposed on the first principal surface side is formed as the unfired multilayer ceramic element assembly (4a).

10. The method for manufacturing a multilayer ceramic electronic device according to any one of Claims 1 to 9, **characterized in that** a region other than the resin introduction portion (11A) in the seat portion (11) is located inside the vertically projected region (R) of the surface mount electronic device (13) mounted on the seat portion (11).

11. The method for manufacturing a multilayer ceramic electronic device according to any one of Claims 1 to 10, **characterized in that** the thickness of the seat portion (11) is 15 to 150 µm.

12. The method for manufacturing a multilayer ceramic electronic device according to any one of Claims 3 to 11, **characterized in that** the unsintered ceramic base material layer (1) is an unsintered ceramic base material layer containing low-temperature-sinterable ceramic as a primary component and the shrinkage restriction layer (2) is a shrinkage restriction layer containing hard-to-sinter ceramic, which is substantially not sintered at a sintering temperature of the low-temperature-sinterable ceramic, as a primary component.

13. The method for manufacturing a multilayer ceramic electronic device according to any one of Claims 1 to 12, **characterized in that** the nonmetallic inorganic powder (21) constituting the seat portion (11) is a ceramic powder which is substantially not sintered at a sintering temperature of the ceramic constituting the unsintered ceramic base material layer.

14. A multilayer ceramic electronic device in which a surface mount electronic device (13) is mounted on a first principal surface (14) of a multilayer ceramic element assembly (4), the multilayer ceramic electronic device being **characterized by** comprising:
a multilayer ceramic element assembly (4) in which ceramic base material layers (1) are laminated and a predetermined first conductor pattern (7) is disposed;
a seat portion (11), cofired with said multilayer ceramic element assembly (4), for mounting the surface mount electronic device (13), the seat portion (11) being disposed in at least a partial region of the first principal surface (14) of the multilayer ceramic element assembly (4), containing a nonmetallic inorganic powder (21) as a primary component, having a second conductor pattern (17) connected to the surface mount electronic device (13), and having a resin introduction portion (11A) located outside a vertically projected region (R) of the surface mount electronic device (13); and
the surface mount electronic device (13) mounted on the seat portion (11) with the second conductor pattern (17) therebetween,
wherein a resin (22) is filled in at least the seat portion (11) containing the nonmetallic inorganic powder (21) as the primary component.

15. The multilayer ceramic electronic device according to Claim 14, **characterized in that** resins (22) having the same composition are filled in the seat portion (11) containing the nonmetallic inorganic powder (21) as a primary component and between the seat portion (11) and the surface mount electronic device (13), the resins (22) being filled through the resin introduction portion (11A).

16. The multilayer ceramic electronic device according to Claim 14 or 15, **characterized in that** the surface mount electronic device (13) is electrically connected to the first conductor pattern (7) of the multilayer ceramic element assembly (4) with the second conductor pattern (17) of the seat portion (11) therebetween.

## Patentansprüche

1. Ein Verfahren zum Herstellen eines Mehrschichtkeramikelektronikbauelements, bei dem ein Oberflächenbefestigungselektronikbauelement (13) auf einer ersten Hauptoberfläche (14) einer Mehrschichtkeramikelementanordnung (4) befestigt ist, wobei das Verfahren **dadurch gekennzeichnet** ist, das es folgende Schritte aufweist:
(a) Vorbereiten einer ungebrannten, mit einem Auflageabschnitt versehenen Mehrschichtkeramikelementanordnung, die mit folgenden Merkmalen versehen ist:
einer ungebrannten Mehrschichtkeramikelementanordnung (4a), in der ungesinterte Keramikbasismaterialschichten (1) laminiert sind und eine vorbestimmte erste Leiterstruktur (7) angeordnet ist, und
einem Auflageabschnitt (11) zum Befestigen des Oberflächenbefestigungselektronikbauelements (13), wobei der Auflageabschnitt (11) in zumindest einer Teilregion der ersten Hauptoberfläche (14) der Mehrschichtkeramikelementanordnung (4) angeordnet ist, ein nichtmetallisches anorganisches Pulver (21) als eine Hauptkomponente enthält, eine zweite Leiterstruktur (17) aufweist, die mit dem Oberflächenbefestigungselektronikbauelement (13) verbunden ist, und einen Harzeinführungsabschnitt (11A) aufweist, der außerhalb einer vertikal vorstehenden Region (R) des Oberflächenbefestigungselektronikbauelements (13) angeordnet ist;
(b) Brennen der ungebrannten, mit einem Auflageabschnitt versehenen Mehrschichtkeramikelementanordnung;
(c) Befestigen des Oberflächenbefestigungselektronikbauelements (13) auf dem Auflageabschnitt (11) der gebrannten, mit einem Auflageabschnitt ausgestatteten Mehrschichtkeramikelementanordnung mit der zweiten Leiterstruktur (17) zwischen denselben; und
(d) Füllen eines Harzes (22) von dem Harzeinführungsabschnitt (11A) in den Auflageabschnitt (11), der das nichtmetallische anorganische Pulver (21) als die Hauptkomponente enthält, und zwischen den Auflageabschnitt (11) und das Oberflächenbefestigungselektronikbauelement (13) und Durchführen von Härten.

2. Das Verfahren zum Herstellen eines Mehrschichtkeramikelektronikbauelements gemäß Anspruch 1, **dadurch gekennzeichnet, dass** der Auflageabschnitt (11), der das nichtmetallische anorganische Pulver (21) als Hauptkomponente enthält, aus einem porigen Keramikverbundkörperversehenen gebildet ist.

3. Das Verfahren zum Herstellen eines Mehrschichtkeramikelektronikbauelements gemäß Anspruch 1 oder Anspruch 2, **dadurch gekennzeichnet, dass** die ungesinterten Keramikbasismaterialschichten (1) und Schrumpfungsbegrenzungsschichten (2) zum Begrenzen von Schrumpfung der ungesinterten Keramikbasismaterialschichten (1) in einer Ebenenrichtung laminiert sind, um die ungebrannte Mehrschichtkeramikelementanordnung (4a) zu bilden.

4. Das Verfahren zum Herstellen eines Mehrschichtkeramikelektronikbauelements gemäß einem der Ansprüche 1 bis 3, **dadurch gekennzeichnet, dass** der Auflageabschnitt (11) mit Durchgangslochleitern als zweite Leiterstruktur (17) versehen ist, während eine Endoberfläche jedes Durchgangslochleiters an der Oberfläche des Auflageabschnitts (11) freigelegt ist, und das Oberflächenbefestigungselektronikbauelement (13) auf der einen Endoberfläche jedes Durchgangslochleiters befestigt ist, die an der Oberfläche freigelegt ist, mit einem elektrisch leitfähigen Verbindungsbauglied zwischen denselben.

5. Das Verfahren zum Herstellen eines Mehrschichtkeramikelektronikbauelements gemäß einem der Ansprüche 1 bis 4, **dadurch gekennzeichnet, dass** die zweite Leiterstruktur (17) des Auflageabschnitts (11) das Oberflächenbefestigungselektronikbauelement (13), das auf dem Auflageabschnitt (11) befestigt ist, und die erste Leiterstruktur (7) der Mehrschichtkeramikelementanordnung (4) verbindet.

6. Das Verfahren zum Herstellen eines Mehrschichtkeramikelektronikbauelements gemäß einem der Ansprüche 1 bis 5, **dadurch gekennzeichnet, dass** das Oberflächenbefestigungselektronikbauelement (13) ein Halbleiterelement aufweist.

7. Das Verfahren zum Herstellen eines Mehrschichtkeramikelektronikbauelements gemäß einem der Ansprüche 1 bis 6, **dadurch gekennzeichnet, dass** in dem Fall, wo eine Mehrzahl von Oberflächenbefestigungselektronikbauelementen (13) auf dem Auflageabschnitt (11) befestigt sind, ein gemeinsamer Harzeinführungsabschnitt (11A) für die einzelnen Oberflächenbefestigungselektronikbauelemente (13) auf dem Auflageabschnitt (11) angeordnet ist, das Harz (22) von dem gemeinsamen Harzeinführungsabschnitt (11A) gefüllt wird, um das Harz (22) in den Auflageabschnitt (11) und zwischen den Auflageabschnitt (11) und die Mehrzahl von Oberflächenbefestigungselektronikbauelementen (13) zu füllen.

8. Das Verfahren zum Herstellen eines Mehrschichtkeramikelektronikbauelements gemäß einem der Ansprüche 1 bis 7, **dadurch gekennzeichnet, dass** Oberflächenbefestigungselektronikbauelemente (15), außer dem Oberflächenbefestigungselektronikbauelement (13), das auf dem Auflageabschnitt (11) befestigt ist, an Regionen der ersten Hauptoberfläche (14) der Mehrschichtkeramikelementanordnung (4) befestigt sind, in denen der Auflageabschnitt (11) nicht angeordnet ist.

9. Das Verfahren zum Herstellen eines Mehrschichtkeramikelektronikbauelements gemäß einem der Ansprüche 3 bis 8, **dadurch gekennzeichnet, dass** eine ungebrannte Mehrschichtkeramikelementanordnung (4a) mit einer Struktur, in der die Schrumpfungsbegrenzungsschicht (2) auf der ersten Hauptoberflächenseite angeordnet ist, als die ungebrannte Mehrschichtkeramikelementanordnung (4a) gebildet ist.

10. Das Verfahren zum Herstellen eines Mehrschichtkeramikelektronikbauelements gemäß einem der Ansprüche 1 bis 9, **dadurch gekennzeichnet, dass** eine andere Region als der Harzeinführungsabschnitt (11A) in dem Auflageabschnitt (11) innerhalb der vertikal vorstehenden Region (R) des Oberflächenbefestigungselektronikbauelements (13) angeordnet ist, das auf dem Auflageabschnitt (11) befestigt ist.

11. Das Verfahren zum Herstellen eines Mehrschichtkeramikelektronikbauelements gemäß einem der Ansprüche 1 bis 10, **dadurch gekennzeichnet, dass** die Dicke des Auflageabschnitts (11) 15 bis 150 µm beträgt.

12. Das Verfahren zum Herstellen eines Mehrschichtkeramikelektronikbauelements gemäß einem der Ansprüche 3 bis 11, **dadurch gekennzeichnet, dass** die ungesinterte Keramikbasismaterialschicht (1) eine ungesinterte Keramikbasismaterialschicht ist, die eine bei niedriger Temperatur sinterbare Keramik als eine Hauptkomponente enthält, und die Schrumpfungsbegrenzungsschicht (2) eine Schrumpfungsbegrenzungsschicht ist, die schwer zu sinternde Keramik als eine Hauptkomponente enthält, die bei einer Sintertemperatur der bei einer niedrigen Temperatur sinterbaren Keramik im Wesentlichen nicht gesintert wird.

13. Das Verfahren zum Herstellen eines Mehrschichtkeramikelektronikbauelements gemäß einem der Ansprüche 1 bis 12, **dadurch gekennzeichnet, dass** das nichtmetallische anorganische Pulver (21), das den Auflageabschnitt (11) bildet, ein Keramikpulver ist, das bei einer Sintertemperatur der Keramik, die die ungesinterte Keramikbasismaterialschicht bildet, im Wesentlichen nicht gesintert wird.

14. Ein Mehrschichtkeramikelektronikbauelement, bei dem ein Oberflächenbefestigungselektronikbauelement (13) auf einer ersten Hauptoberfläche (14) einer Mehrschichtkeramikelementanordnung (4) gebildet ist, wobei das Mehrschichtkeramikelektronikbauelement **dadurch gekennzeichnet ist, dass** es folgende Merkmale aufweist:
eine Mehrschichtkeramikelementanordnung (4), in der Keramikbasismaterialschichten (1) laminiert sind und eine vorbestimmte erste Leiterstruktur (7) angeordnet ist;
einen Auflageabschnitt (11), der gleichzeitig mit der Mehrschichtkeramikelementanordnung (4) gebrannt wird, zum Befestigen des Oberflächenbefestigungselektronikbauelements (13), wobei der Auflageabschnitt (11) in zumindest einer Teilregion der ersten Hauptoberfläche (14) der Mehrschichtkeramikelementanordnung (4) angeordnet ist, ein nichtmetallisches anorganisches Pulver (21) als eine Hauptkomponente enthält, eine zweite Leiterstruktur (17) aufweist, die mit dem Oberflächenbefestigungselektronikbauelement (13) verbunden ist, und einen Harzeinführungsabschnitt (11A) aufweist, der außerhalb einer vertikal vorstehenden Region (R) des Oberflächenbefestigungselektronikbauelement (13) angeordnet ist; und
das Oberflächenbefestigungselektronikbauelement (13), das auf dem Auflageabschnitt (11) befestigt ist, mit der zweiten Leiterstruktur (17) zwischen denselben,
wobei ein Harz (22) in zumindest den Auflageabschnitt (11) gefüllt wird, der das nichtmetallische anorganische Pulver (21) als die Hauptkomponente enthält.

15. Das Mehrschichtkeramikelektronikbauelement gemäß Anspruch 14, **dadurch gekennzeichnet, dass** Harze (22) mit der gleichen Zusammensetzung in den Auflageabschnitt (11) gefüllt werden, der das nichtmetallische anorganische Pulver (21) als eine Hauptkomponente enthält, und zwischen den Auflageabschnitt (11) und das Oberflächenbefestigungselektronikbauelement (13), wobei die Harze (22) durch den Harzeinführungsabschnitt (11A) gefüllt werden.

16. Das Mehrschichtkeramikelektronikbauelement gemäß Anspruch 14 oder 15, **dadurch gekennzeichnet, dass** das Oberflächenbefestigungselektronikbauelement (13) elektrisch verbunden ist mit der ersten Leiterstruktur (7) der Mehrschichtkeramikelementanordnung (4), mit der zweiten Leiterstruktur (17) des Auflageabschnitts (11) zwischen denselben.

## Revendications

1. Procédé de fabrication d'un dispositif électronique en céramique multicouche dans lequel un dispositif électronique de montage en surface (13) est monté sur une première surface principale (14) d'un ensemble d'éléments en céramique multicouche (4), le procédé étant **caractérisé en ce qu'**il comprend les étapes consistant à :
(a) préparer un ensemble d'éléments en céramique multicouche équipé d'une partie de siège non cuits pourvu :
d'un ensemble d'éléments en céramique multicouche non cuits (4a) dans lequel des couches de matériau de base en céramique non frittées (1) sont lamifiées et un premier motif conducteur (7) prédéterminé est disposé, et
d'une partie de siège (11) pour monter le dispositif électronique de montage en surface (13), la partie de siège (11) étant disposée dans au moins une région partielle de la première surface principale (14) de l'ensemble d'éléments en céramique multicouche (4), contenant une poudre inorganique non métallique (21) en tant que composant principal, ayant un deuxième motif conducteur (17) connecté au dispositif électronique de montage en surface (13), et ayant une partie d'introduction de résine (11A) située à l'extérieur d'une région se projetant verticalement (R) du dispositif électronique de montage en surface (13) ;
(b) cuire l'ensemble d'éléments en céramique multicouche équipé d'une partie de siège non cuits ;
(c) monter le dispositif électronique de montage en surface (13) sur la partie de siège (11) de l'ensemble d'éléments en céramique multicouche équipé d'une partie de siège cuits avec le deuxième motif conducteur (17) entre eux ; et
(d) introduire une résine (22), à partir de la partie d'introduction de résine (11A), dans la partie de siège (11) contenant la poudre inorganique non métallique (21) en tant que composant principal et entre la partie de siège (11) et le dispositif électronique de montage en surface (13), et effectuer une cuisson.

2. Procédé de fabrication d'un dispositif électronique en céramique multicouche selon la revendication 1, **caractérisé en ce que** la partie de siège (11) contenant la poudre inorganique non métallique (21) en tant que composant principal est formée à partir d'une céramique poreuse compacte.

3. Procédé de fabrication d'un dispositif électronique en céramique multicouche selon la revendication 1 ou la revendication 2, **caractérisé en ce que** les couches de matériau de base en céramique non frittées (1) et les couches de limitation de retrait (2) pour limiter le retrait des couches de matériau de base en céramique non frittées (1) dans une direction plane sont lamifiées de manière à former l'ensemble d'éléments en céramique multicouche non cuits (4a).

4. Procédé de fabrication d'un dispositif électronique en céramique multicouche selon l'une quelconque des revendications 1 à 3, **caractérisé en ce que** la partie de siège (11) est pourvue de conducteurs de trou d'interconnexion en tant que deuxième motif conducteur (17), tandis qu'une surface d'extrémité de chaque conducteur de trou d'interconnexion est exposée au niveau de la surface de la partie de siège (11), et le dispositif électronique de montage en surface (13) est monté sur ladite surface d'extrémité de chaque conducteur de trou d'interconnexion exposée au niveau de la surface avec un élément de jonction électriquement conducteur entre eux.

5. Procédé de fabrication d'un dispositif électronique en céramique multicouche selon l'une quelconque des revendications 1 à 4, **caractérisé en ce que** le deuxième motif conducteur (17) de la partie de siège (11) connecte le dispositif électronique de montage en surface (13) monté sur la partie de siège (11) et le premier motif conducteur (7) de l'ensemble d'éléments en céramique multicouche (4).

6. Procédé de fabrication d'un dispositif électronique en céramique multicouche selon l'une quelconque des revendications 1 à 5, **caractérisé en ce que** le dispositif électronique de montage en surface (13) comprend un élément semi-conducteur.

7. Procédé de fabrication d'un dispositif électronique en céramique multicouche selon l'une quelconque des revendications 1 à 6, **caractérisé en ce que**, dans le cas où une pluralité de dispositifs électroniques de montage en surface (13) sont montés sur la partie de siège (11), une partie d'introduction de résine (11A) commune aux dispositifs électroniques de montage en surface (13) individuels est disposée sur la partie de siège (11), la résine (22) est introduite à partir de la partie d'introduction de résine (11A) commune de manière à introduire la résine (22) dans la partie de siège (11) et entre la partie de siège (11) et la pluralité de dispositifs électroniques de montage en surface (13).

8. Procédé de fabrication d'un dispositif électronique en céramique multicouche selon l'une quelconque des revendications 1 à 7, **caractérisé en ce que** les dispositifs électroniques de montage en surface (15) autres que le dispositif électronique de montage en surface (13) monté sur la partie de siège (11) sont montés sur des régions dans lesquelles la partie de siège (11) n'est pas disposée, de la première surface principale (14) de l'ensemble d'éléments en céramique multicouche (4).

9. Procédé de fabrication d'un dispositif électronique en céramique multicouche selon l'une quelconque des revendications 3 à 8, **caractérisé en ce qu'**un ensemble d'éléments en céramique multicouche non cuits (4a) ayant une structure dans laquelle la couche de limitation de retrait (2) est disposée sur le premier côté de surface principal est formé en tant qu'ensemble d'éléments en céramique multicouche non cuits (4a).

10. Procédé de fabrication d'un dispositif électronique en céramique multicouche selon l'une quelconque des revendications 1 à 9, **caractérisé en ce qu'**une région autre que la partie d'introduction de résine (11A) dans la partie de siège (11) est située à l'intérieur de la région se projetant verticalement (R) du dispositif électronique de montage en surface (13) monté sur la partie de siège (11).

11. Procédé de fabrication d'un dispositif électronique en céramique multicouche selon l'une quelconque des revendications 1 à 10, **caractérisé en ce que** l'épaisseur de la partie de siège (11) est de 15 à 150 µm.

12. Procédé de fabrication d'un dispositif électronique en céramique multicouche selon l'une quelconque des revendications 3 à 11, **caractérisé en ce que** la couche de matériau de base en céramique non frittée (1) est une couche de matériau de base en céramique non frittée contenant une céramique pouvant être frittée à basse température en tant que composant principal et la couche de limitation de retrait (2) est une couche de limitation de retrait contenant une céramique difficile à fritter, qui est sensiblement non frittée à une température de frittage de la céramique pouvant être frittée à basse température, en tant que composant principal.

13. Procédé de fabrication d'un dispositif électronique en céramique multicouche selon l'une quelconque des revendications 1 à 12, **caractérisé en ce que** la poudre inorganique non métallique (21) constituant la partie de siège (11) est une poudre de céramique qui est sensiblement non frittée à une température de frittage de la céramique constituant la couche de matériau de base en céramique non frittée.

14. Dispositif électronique en céramique multicouche dans lequel un dispositif électronique de montage en surface (13) est monté sur une première surface principale (14) d'un ensemble d'éléments en céramique multicouche (4), le dispositif électronique en céramique multicouche étant **caractérisé en ce qu'**il comprend :
un ensemble d'éléments en céramique multicouche (4) dans lequel les couches de matériau de base en céramique (1) sont lamifiées et un premier motif conducteur (7) prédéterminé est disposé ;
une partie de siège (11), cuite conjointement avec ledit ensemble d'éléments en céramique multicouche (4), pour le montage du dispositif électronique de montage en surface (13), la partie de siège (11) étant disposée dans au moins une région partielle de la première surface principale (14) de l'ensemble d'éléments en céramique multicouche (4), contenant une poudre inorganique non métallique (21) en tant que composant principal, ayant un deuxième motif conducteur (17) connecté au dispositif électronique de montage en surface (13), et ayant une partie d'introduction de résine (11A) située à l'extérieur d'une région se projetant verticalement (R) du dispositif électronique de montage en surface (13) ; et
le dispositif électronique de montage en surface (13) monté sur la partie de siège (11) avec le deuxième motif conducteur (17) entre eux,
dans lequel au moins la partie de siège (11) contenant la poudre inorganique non métallique (21) en tant que composant principal est remplie d'une résine (22).

15. Dispositif électronique en céramique multicouche selon la revendication 14, **caractérisé en ce que** des résines (22) ayant la même composition sont introduites dans la partie de siège (11) contenant la poudre inorganique non métallique (21) en tant que composant principal et entre la partie de siège (11) et le dispositif électronique de montage en surface (13), les résines (22) étant introduites à travers la partie d'introduction de résine (11A).

16. Dispositif électronique en céramique multicouche selon la revendication 14 ou 15, **caractérisé en ce que** le dispositif électronique de montage en surface (13) est connecté électriquement au premier motif conducteur (7) de l'ensemble d'éléments en céramique multicouche (4) avec le deuxième motif conducteur (17) de la partie de siège (11) entre eux.
